Europäisches Patentamt

European Patent Office

Office européen des brevets

(19)

(11) EP 1 324 336 A1

(12) EUROPEAN PATENT APPLICATION
published in accordance with Art. 158(3) EPC

(43) Date of publication:
02.07.2003 Bulletin 2003/27

(51) Int Cl.⁷: **G11B 20/14**, G11B 20/10, G11B 20/12, G11B 7/007, G11B 11/105

(21) Application number: 01970260.4

(22) Date of filing: 27.09.2001

(86) International application number:
PCT/JP01/08478

(87) International publication number:
WO 02/029811 (11.04.2002 Gazette 2002/15)

(84) Designated Contracting States:
AT BE CH CY DE DK ES FI FR GB GR IE IT LI LU MC NL PT SE TR
Designated Extension States:
AL LT LV MK RO SI

(30) Priority: 02.10.2000 JP 2000302597

(71) Applicant: MATSUSHITA ELECTRIC INDUSTRIAL CO., LTD.
Kadoma-shi, Osaka 571-8501 (JP)

(72) Inventors:
• HINO, Yasumori
Ikoma-shi, Nara 630-0112 (JP)

**Description**

TECHNICAL FIELD

The present invention relates to a recording medium in which digital data are recorded, a recording apparatus, a recording method, a reproducing apparatus and a reproduction method for such a recording medium.

BACKGROUND ART

Various types of recording formats for recording digital data in a recording medium have been proposed over the recent years.
A recording format for an optical disk according to a conventional example will now be described with reference to drawings.

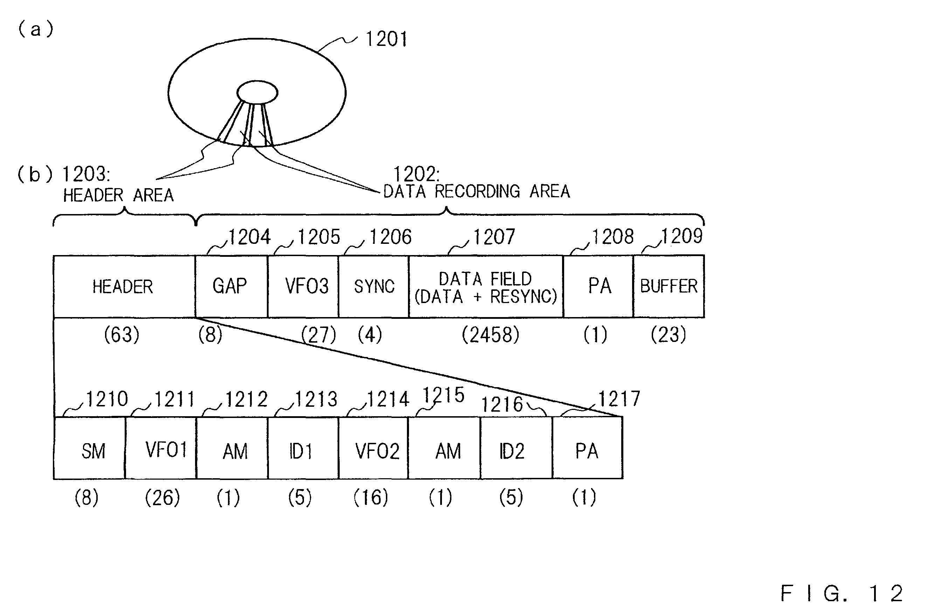

Fig. 12 shows a magneto-optic disk of a recording format which utilizes the (1-7) encoding scheme which is generally used.
Part (a) of Fig. 12 schematically shows an overall structure of an optical disk according to a conventional example.
In part (a) of Fig. 12, a magneto-optic disk 1201 comprises a spiral track which runs from an inner round toward an outer round of the magneto-optic disk.
The recording track is divided by pre-pit areas (header areas) 1203, which extend in the radius direction of the magneto-optic disk, into a plurality of data recording areas 1202.
The pre-pit areas (header areas) 1203 contain pre-formatted data which are generated as a plurality of pre-pits, and the pre-formatted data constitute a header portion having 63 bytes.
The header portion which is recorded in the pre-pit area 1203, a GAP which is recorded in the data recording area 1202 and the like are joined together, thereby forming one sector (part (b) of Fig. 12).
In part (b) of Fig. 12, the figures in parentheses denote data byte counts of the respective data.
The header portion 1203 having 63 bytes comprises a sector mark (SM) 1210 having eight bytes which is indicative of the top of the sector, a VFO1 (Variable Frequency Oscillator, 1211) having 26 bytes and a VFO2 (1214) having 16 bytes which are for generating a synchronous clock which is used to reproduce an ID portion, AMs (1212 and 1215) having one byte, an ID1 (1213) having five bytes and an ID2 (1216) having five bytes which contain address information regarding the sector, and a postamble (PA, 1217) having one byte, and data are generated as the pre-pits.
The data recording area 1202 contains a GAP (1204) having eight bytes, a VFO3 (1205) having 27 bytes, a Sync (synchronization, 1206) having four bytes, a data field (1207) having 2458 bytes, a postamble (suffix data, PA, 1208) having one byte and a buffer portion (1209) having 23 bytes, and data are recorded as a recording film which exhibits vertical magnetic anisotropy is magnetized.
The VFO3 (1205) is a signal having a repetitive constant pattern, and used to synchronize a clock which is to read out data which are recorded in the data field 1207.
Meanwhile, the Sync 1206 is data which are used to synchronize a byte of data which are recorded in the data field 1207 which follows the Sync 1206. The Sync 1206 may contain data which are for encoding or decoding of top data which are recorded in the data field 1207.
Data encoded by the (1-7) encoding scheme are recorded in the data fields 1207. Resynchronization signals (ReSync signals) are repeatedly inserted at constant intervals between thus encoded pieces of data. Even if there is an out-of-synch attributed to a defect or the like in the disk, it is possible to recover synchronization by means of the re-synchronization signals.
The postamble (suffix data) 1208 is a signal for decoding last data representing a recording signal encoded by the (1-7) encoding scheme, and is 1-byte data. Owing to the postamble 1208, encoding and decoding by the (1-7) encoding scheme ends within the sector.
The buffer portion 1209 is disposed to absorb a variation caused by rotations of a motor, jittering of a recording reference clock, etc.
A phase error regarding a recording position attributed to a rotation-induced variation during recording is absorbed by the VFO3 (1205), the re-synchronization signal inserted in the data field 1207 and the buffer portion (1209).
In order to complete data processing in units of sectors, the data field 1207 and other signals have a data volume which is an integer multiple of one byte.
The (1-7) encoding scheme will now be described with reference to Table 1.
When a DC component is contained in recording data which are recorded in a recording medium, a problem occurs such as a waveform interference, a distorted waveform due to a low-frequency component, a phase lock failure of a data clock during reproduction, or the like.
Therefore, it is preferable to record data which are encoded by an encoding scheme according to which encoded data do not a certain amount of contain DC components or more. Generally used for suppression of DC components contained in encoded data is an encoding scheme which ensures that post-conversion encoded data do not contain a bit string of the same values in a row over a certain length or a longer length (so that a certain number of zeroes or more zeroes will not appear successively, for instance), namely, a run length limit encoding scheme which is an encoding scheme which restricts a run length (the length of the bit string of the successive same values).

The (1-7) encoding scheme is one of encoding schemes which restrict a run length, according to which in post-conversion encoded data, the value 1 does not appear in a row (there are always zeroes before and after one) and the maximum number of successive pieces of the value 0 (bit count) is limited to seven (The number of successive zeroes is one through seven).

Where the (1-7) encoding scheme is used, assuming that a time length of one bit of encoded data is T, a time length between a certain transition point from 0 to 1 and the next transition point from 0 to 1 is a time length ranging from 2T to 8T. This prevents the problem described above and makes it possible to extract clock information from a reproduction signal.

When data encoded by the (1-7) encoding scheme are further encoded by an NRZI scheme (Non-Return to Zero Inversion), it becomes possible to decrease a basic frequency wavenumber of the signal down to a half without losing the information. This allows to increase a data rate for data which are to be recorded in a recording medium. To encode data encoded by the (1-7) encoding scheme in which 1 does not appear successively further by the NRZI scheme virtually means to divide this encoded data down to a half.

Encoding rules of the (1-7) encoding scheme will now be described with reference to a conversion table in Table 1. According to the (1-7) encoding scheme, 2-bit input data are encoded into 3-bit encoded data. This encoding conversion rule is determined by a combination of 1-bit encoded data generated through immediately precedent encoding, 2-bit input data to be encoded (input data which are an encoding target) and 2-bit input data which follow the input data to be encoded (data to be encoded next).

Table 1

(1 - 7) ENCODING TABLE

| NO. | INPUT DATA | | | OUTPUT DATA |
| --- | --- | --- | --- | --- |
| | LAST BIT OF ENCODED DATA GENERATED IMMEDIATELY BEFORE | INPUT DATA TO BE ENCODED | SUBSEQUENT INPUT DATA | ENCODED DATA |
| 1 | X | 00 | 0X | 001 |
| 2 | 0 | 00 | 1X | 000 |
| 3 | 1 | 00 | 1X | 010 |
| 4 | 0 | 01 | 0X | 001 |
| 5 | 0 | 01 | 1X | 000 |
| 6 | 1 | 01 | 00 | 010 |
| 7 | 1 | 01 | NOT 00 | 000 |
| 8 | 0 | 10 | 0X | 101 |
| 9 | 0 | 10 | 1X | 010 |
| 10 | 0 | 11 | 00 | 010 |
| 11 | 0 | 11 | NOT 00 | 100 |

(X DENOTES 0 OR 1)

Meanwhile, during decoding by the (1-7) encoding scheme, thus encoded 3-bit encoded data are decoded into 2-bit data using a reverse conversion table in Table 2. The decoding conversion rule is determined by a combination of last two bits of 3-bit encoded data which was a decoding target immediately before, 3-bit encoded data to be decoded (input data which are a decoding target) and 2-bit encoded data which follow the encoded data which are to be decoded (encoded data which are to be decoded next).

TABLE 2

(1 - 7) DECODING TABLE

| NO. | INPUT DATA | | | OUTPUT DATA |
| | LAST TWO BITS OF IMMEDIATELY PRECEDENT ENCODED DATA | ENCODED DATA TO BE DECODED | SUBSEQUENT ENCODED DATA | DECODED DATA |
| --- | --- | --- | --- | --- |
| 1 | 10 | 000 | NOT 11 | 00 |
| 2 | 0X | 000 | NOT 11 | 01 |
| 3 | 00 | 001 | 0X | 01 |
| 4 | 01 OR 10 | 001 | 0X | 00 |
| 5 | X0 | 010 | 00 | 11 |
| 6 | X0 | 010 | 01 OR 10 | 10 |
| 7 | 01 | 010 | 00 | 01 |
| 8 | 01 | 010 | 01 OR 10 | 00 |
| 9 | X0 | 100 | NOT 11 | 11 |
| 10 | X0 | 101 | 0X | 10 |

(X DENOTES 0 OR 1)

Thus, when the (1-7) encoding scheme is used, for decoding of encoded data which were encoded, it is necessary to use not only the encoded data which were encoded and are a decoding target but also encoded data which was a decoding target before this encoded data and subsequent encoded data.

Therefore, in a recording format shown in Fig. 12, the Sync 1206 containing prefix encoded data is placed before the data portion 1207 of each sector so as to decode the top data, while the postamble (suffix data) 1208 is placed after the data portion 1207 so as to decode the last data.

According to other encoding schemes, precedent and subsequent data are not needed for encoding or decoding, a data string having a predetermined length is uniquely converted into an encoded data string having a predetermined length with reference to a predetermined conversion table during encoding, and an encoded data string having a predetermined length is uniquely converted into a data string having a predetermined length with reference to a predetermined conversion table during decoding. When such an encoding scheme is used, it is not necessary to add decoding-purpose data before and after a data portion unlike described above.

For example, the standard called ASMO requires to use the NRZI+ method which is one type of such encoding schemes, to thereby record in divided data recording areas in a distributed manner.

In a conventional optical memory, a resolution for reproduction of a signal is determined almost by the wavelength $\lambda$ of reproduction light and the numerical aperture (NA) of an object lens, and a pit pitch at a detection limit is approximately $\lambda /(2 \cdot NA)$. However, in these years, since it is not easy to shorten the wavelength of reproduction light or increase the numerical aperture of an object lens, recording mediums, reproduction methods and the like are improved in an effort to enhance a recording density of information. With respect to magneto-optic recording mediums (magneto-optic disks) in particular, various types of ideas for improvement in recording density of information have been proposed.

For instance, according to a technique described in Japanese Patent Application Laid-Open No. 6-290496, magnetic walls coming under a reproduction light beam are moved one after another, the movements of the magnetic walls are detected, and a resolution for reproduction is improved beyond a detection limit which is determined by the wavelength mentioned above and the numerical aperture of an object lens (DWDD scheme). This technique permits to obtain a particularly favorable reproduction signal, when at least one layer or all layers of a reproduction layer, which is a first magnetic layer wherein a magnetic wall coming under a reproduction light beam moves, a recording layer which holds a recording signal, and a switching layer which controls magnetic coupling of the recording layer and the reproduction layer are magnetically isolated between information tracks.

In this manner, use of a super resolution technique such as the DWDD scheme makes it possible to greatly improve a recording density beyond an optical limit of $\lambda/(2 \cdot NA)$ in a data area which is for rewriting data. However, preformatted addresses, control information for tracking and the like are engraved on an optical disk as concave and convex pits. A recording density of these pits is under a certain restriction by a reproduction limit which is dependent upon the value $\lambda/(2 \cdot NA)$. This leads to problems such as a deterioration in recording density of an optical disk, a drop in format efficiency, etc. This will now be briefly described.

In a conventional optical disk, grooves, areas between the grooves and the like are used as recording tracks. Since a signal for tracking control is obtained from these grooves, there is a restriction upon an optical resolution which is for a track pitch to obtain a tracking guide signal from these grooves. Because of this, it is very difficult to reduce the track pitch. Where a conventional recording and reproducing method is used, when a track pitch is reduced, cross talk from an adjacent track makes reproduction difficult. Since a track pitch restricted by cross talk is approximately equal to a lower limit track pitch which is for obtaining a tracking signal from a groove, this is not a big problem in a conventional optical disk. However, where a reproduction method utilizing DWDD is used, since a signal is read out during a super resolution operation by means of movements of a magnetic wall, cross talk from an adjacent track is reduced. This permits to record and reproduce with a track density which is the same or higher than a conventional track density. Still, it is not possible to improve a track density because of a track pitch restriction, since a tracking guide signal is obtained. Among proposed as means to overcome this problem is an optical disk using the sample servo method in which adjacent tracks share wobble pits which are for detection of a tracking signal and data recording areas are formed as grooves (Patent Application No. 2000-188200, PCT/JP01/05232 (which is a patent application which currently does not stand laid open, and thus, is not prior art) which is a patent application in which an inventor is the same as the inventor for this application). This invention realizes a high density track pitch.

The restriction upon a recording density in these pit portions by a reproduction limit which is dependent on the value $\lambda/(2 \cdot NA)$ gives rise to the following problem in terms of a format efficiency.

Considering a sector that an address has 40 bytes and data have 2048 bytes for instance, in the case of a conventional optical disk (a medium which does not use a super resolution reproduction method), a recording density in address portions (areas where addresses are recorded) is 0.5μm/bit and a recording density in data portions (areas where data are recorded) is similarly about 0.5μm/bit.

In this case, a proportion of address data to the entire data (which is called "address redundancy") is $0.5 \times 40 \times 8 / (0.5 \times (40 + 2048) \times 8) = 1.91$ %.

In the case of an optical disk utilizing a super resolution reproduction method such as the DWDD type (or the CAD type, the FAD (Front Aperture Detection) type or the RAD (Rear Aperture Detection) type, etc.), while a recording density in an address portion is 0.5µm/bit, a recording density in a data portion is about 0.1µm/bit, and hence, the address redundancy greatly increases to $0.5 \times 40 \times 8 / ((0.5 \times 40 + 0.1 \times 2048) \times 8) = 8.9$ %. The poor format efficiency is attributed to a format structure of a conventional optical disk in which one address is added to one sector.

To overcome the poor format efficiency, such a structure has been proposed in which a disk is divided into a plurality of segments and 1-bit addresses are added to the segments (Japanese Patent Application Laid-Open No. 11-021885, Japanese Patent Application Laid-Open No. 11-329265 and Patent Application No. 2000-339516 (which is a patent application which currently does not stand laid open, and thus, is not prior art) which are patent applications in which an inventor is the same as the inventor for this application). This eliminates the one-to-one relationship between addresses and sectors and accordingly improves a format efficiency.

While a track density needs be improved when an optical disk is to be made a high-density optical disk using super resolution reproduction such as DWDD, a track density beyond an optical resolution of recording/reproduction light is indispensable. To realize such a high density, the sample servo method is essential as a tracking method as described in relation to the conventional techniques. Where the sample servo method is used, data in a sector which is a unit for one rewriting is divided and recorded over a plurality of segments. An optical disk drive using a conventional sample servo method, for the purpose of realizing such division and recording of data, uses a modulation code which permits to execute modulation and demodulation regardless of the dependency upon precedent and subsequent data during recording and reproduction. Examples are the NRZI modulation method in the HS standard, the NRZI+ modulation method in the ASMO standard, the 4-15 modulation method as a position modulation method, etc. Modulation codes for these are codes under no run length restriction, or codes under a very long run length restriction even if the codes are under restriction.

However, for realization of high-density recording with a recording/reproduction film using DWDD, a restriction upon a modulation code attributed to a reproduction characteristic of a recording film is created. A DWDD reproduction signal is generated as a magnetic wall toward the traveling direction of a light beam. However, as the length of a mark for recording becomes long, a magnetic wall against the traveling direction of the light beam, too, moves. A signal generated in accordance with the movements of the magnetic walls is called a ghost signal, and significantly disturbs reproduction of data. Hence, it is necessary to prevent generation of the ghost signal. The probability of ghost signal generation becomes high when the length of a recording mark reaches a certain level or more. Noting this, it is desirable that the length of a recording mark, which is to be recorded in a DWDD recording film, is as short as possible. To a modulation method for DWDD, codes under a run length restriction such as 1-7 codes and 2-7 codes are therefore suitable.

In addition, it is necessary to improve a linear recording density so as to expand a recording capacity of a disk. In this case, a limit on a linear recording density is determined by a limit over the length of a mark which can be recorded and reproduced in a DWDD-type recording/reproduction film. This is because the intensity of a DWDD-type reproduction signal is not dependent upon an optical resolution of reproduction light at all. A limit over the length of a mark which can be recorded and reproduced in a DWDD-type recording/reproduction film is normally about 0.1 µm. For an improvement in recording density per bit beyond a limit over the length of a mark which can be recorded and reproduced as well, it is advantageous to perform encoding with a run length restriction and record and reproduce data. Where 1-7 encoding is executed for instance, a linear recording density is 0.075µm/bit when the minimum length of a mark which can be recorded is 0.1µm, while where 2-7 encoding is executed, a linear recording density is 0.067µm/bit when the mark length is 0.1µm, thereby shortening the length per bit than the minimum recording mark length and improving a recording density.

The standard known as ASMO described in relation to the conventional techniques, too, requires to divide a sector which is a unit for one rewriting into a plurality of recording areas for NRZI+ encoding and recording. During this NRZI+ encoding, a run length restriction is very long and it is accordingly difficult to extract a demodulation clock from a reproduction signal. The ASMO standard therefore uses an external clock system which generates recording/reproduction clocks from pits engraved in advance in a disk. According to a conventional sample servo method which is generally used, too, recording/reproduction clocks are generated from pits engraved in advance in a disk, in a similar fashion. However, use of a super resolution reproduction method such as the DWDD scheme in this manner in an effort to improve a linear recording density leads to the following problem. It is not possible to perform super resolution reproduction on clock pits which are for generation of a reference clock for recording and reproduction, and therefore, a reproduction limit is an optical limit of a light beam. The limit is normally about 0.5µm. On the contrary, a reproduction limit of a DWDD signal, which is read out by a super resolution reproduction method, is about 0.1µm which is as five times high as or higher, a reproduction clock extracted at a reproduction limit of 0.5µm is insufficient as a clock for reproduction of a 0.1µm-mark, and thus, the accuracy of clocks runs short. Hence, it is necessary to extract a highly accurate reproduction clock from a reproduction signal for realization of a high density by a super resolution reproduction method. However, a conventional optical disk complying with the ASMO standard or a sample servo scheme is on an assumption that a reproduction clock is extracted from a clock pit, and a modulation code uses a modulation method with which it is not possible to extract a reproduction clock from a reproduction signal. With an optical disk system using a conventional sample servo method or the like which requires to divide a sector which is a unit for rewriting into a plurality of recording areas, it is not possible to execute recording or reproduction at a high density using super resolution such as that of the DWDD type.

To solve the problem described above, it is necessary to restrict the minimum recording mark length and the maximum recording mark length using a run length limit encoding scheme (which may be the (1-7) encoding scheme or the like for instance), prevent ghost over a long mark or a bit reproduction error over a single mark, and extract a reproduction clock from an inversion part of a reproduction signal which is generated as a result of the run length restriction mentioned above. Further, since it is necessary to use a sample servo method for the purpose of improving a track density as described above, it is necessary to divide a sector which is a unit for rewriting into segments which are a plurality of areas and record. However, when the run length limit encoding scheme described above is used, in order to ensure that encoding and decoding end within one sector or one continuous data recording area, it is necessary to place a prefix data and a suffix data respectively before and after encoded data to be recorded.

However, when prefix data and a suffix data are placed respectively before and after encoded data to be recorded, an effective data recording density of this recording medium decreases.

Particularly in the event that a recording track is divided into a number of data recording areas and data are recorded in such a manner that encoding and decoding complete within one continuous data recording area (i.e., in the event that one round of a disk-shaped recording medium is divided into 1000 or more data recording areas for instance), an effective data recording density (a density which is obtained by converting a data volume of recording data per unit surface area (channel bit count) into a data volume of pre-encoding data (input data)) of this recording medium largely decreases.

Further, the following problem occurs when a track density is improved by a sample servo method and a sector which is a unit for rewriting is divided into segments which are a plurality of areas. In a data recording area which is in the vicinity of a pit area which is for detection of a tracking servo signal, birefringence changes in the data recording area because of an influence by a pre-pit area, thereby the envelope of a reproduction signal changes (This envelope variation will be hereinafter referred to as a skew distortion.). In a reproducing apparatus, a skew distortion makes it difficult to binarize a reproduction signal (i.e., to digitize one bit) an area near a pre-pit area accordingly becomes unusable as a data recording area, which serves as a cause of a deterioration in recording density of the high-density optical disk. While there is a method of reducing a skew distortion as much as possible to thereby use a data recording area which is in the vicinity of a pre-pit area, in this case, the skew distortion changes substantially because of a phase difference between P-polarized light and S-polarized light of an optical pick-up which executes reproduction, and therefore, in order to perform reproduction with little skew distortion, it is necessary to ensure that the phase difference of the optical pick remains within ±5 degrees. This also serves as a difficulty against commercialization of a high-density optical disk.

The present invention aims at providing means which encodes data of a sector which is a unit for rewriting under a run length restriction, divides into a plurality of areas and records and accordingly providing a high-density optical disk. In the case of a recording and reproducing medium in which recording and reproduction are executed by a super resolution reproduction method according to which a data recording area is beyond an optical resolution, the present invention brings about an even more significant effect. The present invention also aims at a recording medium in which such data are recorded which makes it easy to accurately binarize a reproduction signal which has a skew distortion (a low-frequency waveform distortion) or a differential signal between two consecutive reproduction signals.

DISCLOSURE OF INVENTION

The first invention is directed to a recording medium, comprising: a pre-pit area comprising pre-pits; and a plurality of data recording areas which are divided by the pre-pit area and in which a data block is recorded which is obtained by dividing one data stream which is formed by encoded data which are encoded by an encoding scheme including a run length limit encoding scheme, wherein in at least one data recording area, data having a predetermined value of at lease one bit are further recorded in front of the data block.

In a conventional recording medium, encoding and decoding complete within one data recording area.

For example, a conventional recording medium which uses a run length limit encoding scheme has a structure that prefix data, a data block and suffix data are recorded in each data recording area and encoding and decoding end within each data recording area.

With prefix data (which may be 001 or the like for instance) added to and recorded at the top of each data recording area, it is possible to decode top data in the data block, and with constant data (which may be 001 or the like for instance) added to and recorded at the end of each data recording area, it is possible to decode last data in the data block (excluding the added data).

In the conventional recording medium which uses the run length limit encoding scheme, since encoding and decoding complete within each one of the data recording areas, it is necessary that decoding-purpose data are added to and recorded at the top and the end of each data recording area, which deteriorates an effective recording density of the recording medium as a whole.

The present invention achieves an effect that it is possible to realize a recording medium which has a high effective recording density, owing to continuity between encoded data belonging to each data recording area (e.g., a data recording area in each segment) and encoded data belonging to precedent and subsequent data recording areas.

According to the present invention, addition of small data makes it possible to divide a data volume equivalent to one sector (which is a unit of a chunk of data to be recorded or reproduced, and is one ECC block in an embodiment) for instance into a plurality of segments and record.

Hence, unlike the conventional recording medium, it is not necessary to ensure that a channel bit count (recordable bit count) of one data recording area (e.g., a data recording area in each segment) is the same as a channel bit count of one sector in the recording medium according to the present invention. The recording medium according to the present invention has a higher level of freedom regarding a format than the conventional recording medium has.

The present invention achieves an effect that it is possible to realize a recording medium which has a high recording density.

The present invention achieves an effect that particularly in a recording medium wherein one sector is divided into a number of data recording areas (e.g., a disk-shaped recording medium in which a recording track whose length is one round is divided into 1000 or more data recording areas), a recording medium which has a high effective recording density is realized.

In an optical disk, for example, in a portion where a beam spot of a light beam has just moved from a pre-pit area to a data recording area, a reproduction signal has a large low-frequency skew distortion. Hence, it is difficult to binarize a reproduction signal which was reproduced in the conventional recording medium.

In the recording medium according to the present invention, since predetermined additional data of one bit or more are recorded at the beginning of each data recording area, it is possible to accurately binarize a reproduction signal utilizing this, as in a reproducing apparatus according to an embodiment.

The present invention achieves an effect that it is possible to realize a recording medium which permits a reproducing apparatus to accurately binarize a reproduction signal which contains a skew distortion (a low-frequency waveform distortion).

The section reading, "plurality of data recording areas which are divided by the pre-pit area and in which a data block is recorded which is obtained by dividing one data stream which is formed by encoded data which are encoded by an encoding scheme including a run length limit encoding scheme" refers to data streams of encoded data which are encoded by an encoding scheme including a run length limit encoding scheme, which means that a data stream in which adjacent pieces of encoded data are associated with each other is recorded over a plurality of data recording areas.

Hence, for instance, for the purpose of decoding encoded data at the top of a data block recorded in a data recording area, encoded data in a precedent data block are used, while for the purpose of decoding encoded data at the end of the data block recorded in the data recording area, encoded data in a subsequent data block are used.

Thus, it is not necessary to add and record decoding-purpose data at the top of each data recording area (excluding the top data recording area), or to add and record decoding-purpose data at the end of each data recording area (excluding the last data recording area).

Where it is not necessary to use encoded data in a precedent data block for the purpose of decoding encoded data at the top of a data block recorded in a data recording area, this data block and the precedent data block belong to different data streams.

The "pre-pit" is a physical concave or convex portion disposed in a recording medium. An example is a pre-pit formed on an optical disk substrate.

The "run length limit encoding scheme" includes the (1-7) encoding scheme, the (2-7) encoding scheme and the like. In the event that a recording density remains the same, such an encoding scheme generally permits to extend the shortest recording mark longer than a recording density per bit and restricts the longest recording mark, thereby allowing to generate a reference clock for reproduction from a reproduction signal.

The "recording medium" is any desired medium (any desired recording element, a medium having any desired shape) in which digital data are recorded. Examples are optical disks (including phase-conversion optical disks and magneto-optical disks), magnetic cards and the like.

The "data having a predetermined value of at lease one bit" may be a known value or a value which is unknown at the time of reproduction. Being "known" means being known at the time of recording of this data or reproduction of this data. For instance, this may be a certain value (0 or 1), data at the last one bit of an immediately precedent data block (The data are known at the time of recording of the 1-bit data.), or data at the last one bit recorded in an immediately precedent data recording area (The data are known at the time of reproduction of the 1-bit data.).

The channel bit count of the added data is any desired figure which is 1 or larger.

The second invention is directed to a recording medium, comprising: a pre-pit area comprising pre-pits; and a plurality of data recording areas which are divided by the pre-pit areas and in which a data block is recorded which is obtained by dividing one data stream which is formed by encoded data which are encoded by an encoding scheme including a run length limit encoding scheme, wherein in at least one data recording area, data having the same value as the last one bit of the encoded data in the data recording area which is before the data recording area are further recorded in front of the data block.

The present invention achieves an effect that it is possible to realize a recording medium which has a high effective recording density, owing to continuity between encoded data belonging to each data recording area and encoded data belonging to precedent and subsequent data recording areas.

The present invention achieves an effect that it is possible to realize a recording medium which has a high effective recording density.

The present invention achieves an effect that it is possible to realize a recording medium which permits a reproducing apparatus to accurately binarize a reproduction signal which contains a skew distortion (a low-frequency waveform distortion).

In a reproducing apparatus for the recording medium according to the present invention in which encoded data encoded by a run length limit encoding scheme and NRZI-converted for instance are recorded, as a differential signal between two consecutive reproduction signals is generated, it is possible to decode the NRZI-converted encoded data without influenced by a skew distortion and accordingly correct an error.

The present invention achieves an effect that it is possible to realize a recording medium which can be reproduced using a reproducing apparatus which has a simple structure.

The "data having the same value as the encoded data at the last one bit in the data recording area which is before the data recording area" may have one bit or a plurality of bits (and the plurality of bits are all "the same value as the encoded data at the last one bit").

The third invention is directed to the recording medium of the first invention, wherein the data block has the encoded data in a data volume which is an integer multiple of 2 if a data volume is converted into a volume of data before being encoded by a run length limit encoding scheme.

According to the (1-7) encoding scheme for example, 2-bit input data are converted into three bits, and encoded data are generated in units of three bits (the number of channel bits).

Since a data block recorded in the recording medium according to the present invention has a data capacity which is an integer multiple of 2 (The capacity of a data block is expressed as an effective data size as it is before encoded by a run length limit encoding scheme.), it is possible to simplify a control circuit for an encoder which encodes data in units of three channel bits (which correspond to the 2-bit input data) and a decoder which decodes data in units of three channel bits (and it is possible to simplify a processing circuit which is at a joint between adjacent data blocks in particular).

In addition, it is possible to select the size of a data block in units of two bits which are smaller values than units of eight bits or the like according to a conventional technique.

An optimal channel bit count M of a data block is expressed by the following formulas, where a channel bit count of bits which can be physically recorded in each data recording area is N, a channel bit count of data other than in data blocks is K, a unit in which data are processed is L, and a channel bit count of bits which are not used among the channel bit count N is P:

$$M = L \times TRUNC\ ((N - K)\ /\ L)$$

$$P = N - (M + K) = MOD\ ((N - K)\ /\ L)$$

The symbol TRUNC () denotes a function for generating a numerical figure which consists only of an integer portion of a numerical figure in parentheses (i.e., for rounding down decimal figures). The symbol MOD () denotes a function which expresses a remainder which is obtained by division described in ().

While the maximum value of P is seven bits in a conventional recording medium wherein the channel bit count is eight bits for instance, the maximum value of P, when expressed as the number of channel bits, is two channel bits in the recording medium according to the present invention.

The present invention achieves an effect that it is possible to realize a recording medium which is less wasted and has a high recording density.

The fourth invention is directed to a recording apparatus, comprising: an encoding unit which generates a plurality of data blocks which are obtained by dividing one data stream which is formed by encoded data which are obtained by encoding input data by an encoding scheme including a run length limit encoding scheme; a data adding unit which adds data having a predetermined value of at lease one bit to the top of at least one of the divided data blocks and generates a data block which contains thus added data; and a recording unit which records the data block which contains thus added data in the recording medium.

The present invention achieves an effect that it is possible to realize a recording medium which has a high effective recording density, owing to continuity between encoded data belonging to each data recording area and encoded data belonging to precedent and subsequent data recording areas.

The present invention achieves an effect that it is possible to realize a recording apparatus for recording encoded data at a high effective recording density particularly in a recording medium wherein one sector is divided into a number of data recording areas (e.g., a disk-shaped recording medium in which a recording track whose length is one round is divided into 1000 or more data recording areas).

In an optical disk for example, since a reproduction signal has a large low-frequency skew distortion in a portion where a beam spot of a light beam has just moved from a pre-pit area to a data recording area, it is difficult to binarize a reproduction signal according to a conventional technique. In the recording medium according to the present invention, predetermined data are recorded at the beginning of each data recording area. Hence, it is possible to accurately binarize a reproduction signal utilizing this, as in a reproducing apparatus according to an embodiment for example. The present invention achieves an effect that it is possible to realize a recording apparatus for recording data which, utilizing the added data, is capable of accurately binarizing a reproduction signal even when the reproduction signal has a skew distortion (a low-frequency waveform distortion).

The "data block which contains thus added data" means data having a predetermined value of at lease one bit and a data block as they are combined with each other.

The encoding unit may divide input data first to thereby generate a plurality of data blocks, and then encode each data block by an encoding scheme including a run length limit encoding scheme to thereby generate a plurality of data blocks of encoded data.

Alternatively, the encoding unit may first encode one data stream by an encoding scheme including a run length limit encoding scheme, and then divide thus encoded data stream into a plurality of data blocks.

Alternatively, the encoding unit may first encode one data stream by a run length limit encoding scheme, then divide thus encoded data stream into a plurality of data blocks, and thereafter convert each data block by other conversion method (such as NRZI conversion).

The encoding unit according to each invention includes all these structures described above but is not limited to these examples above. This is similar as to the encoding unit according to the fifth invention and the encoding steps according to the eleventh invention and the twelfth invention.

The encoding unit and the data adding unit may constitute blocks which are independent of and separate from each other, or may have a structure which is the two integrated with each other in such a manner that the two can not be separated from each other.

The fifth invention is directed to a recording apparatus, comprising: an encoding unit which generates a plurality of data blocks which are obtained by dividing one data stream which is formed by encoded data which are obtained by encoding input data by an encoding scheme including a run length limit encoding scheme; a data adding unit which adds data having the same value as the last one bit of the encoded data in the data block which is before at least one of the divided data blocks to the top of at least one of the divided data blocks and generates a data block which contains thus added data; and a recording unit which records the data block which contains thus added data in the recording medium.

The present invention achieves an effect that it is possible to realize a recording apparatus which records data in a recording medium which has a high effective recording density, owing to continuity between encoded data belonging to each data recording area and encoded data belonging to precedent and subsequent data recording areas.

The present invention achieves an effect that it is possible to realize a recording apparatus which records encoded data in a recording medium at a high effective recording density and with a high error correcting capability.

The present invention achieves an effect that it is possible to realize a recording apparatus which records, in a recording medium data which permit a reproducing apparatus to accurately binarize a reproduction signal which contains a skew distortion (a low-frequency waveform distortion).

The present invention achieves an effect that it is possible to realize a recording apparatus which records, in a recording medium, data which can be reproduced using a reproducing apparatus which has a simple structure.

The sixth invention is directed to the recording apparatus of the fourth invention, wherein the data block has the encoded data in a data volume which is an integer multiple of 2 if a data volume is converted into a volume of data before being encoded by a run length limit encoding scheme.

Since a data block recorded in the recording medium according to the present invention has a data capacity which is an integer multiple of 2 (The capacity of a data block is expressed as an effective data size as it is before encoded by a run length limit encoding scheme.), it is possible to simplify a control circuit for an encoder which encodes data in units of three channel bits (which correspond to the 2-bit input data) and a decoder which decodes data in units of three channel bits (and it is possible to simplify a processing circuit which is at a joint between adjacent data blocks in particular).

In addition, it is possible to select the size of a data block in units of two bits which are smaller values than units of eight bits or the like according to a conventional technique.

The present invention achieves an effect that it is possible to realize a recording apparatus having a simple structure which records, in a recording medium, data at a high recording density while avoiding a wasteful use.

The seventh invention is directed to the recording apparatus of any one of the fourth through the sixth inventions, wherein the encoding unit or the data adding unit adds, after the last piece of the encoded data, data having a predetermined value of n bits (where n is any desired positive integer).

After recording and reproduction of encoded data which were encoded by an encoding scheme including a run length limit encoding scheme using data which follows data which are an encoding target, for the purpose of decoding the last data in the data stream, the subsequent data are further needed.

The recording apparatus according to the present invention therefore requires to add data having a certain value (which may be 001 or the like for instance) after the last encoded data in the data stream.

The figure n is any desired value. For instance, data having n bits may be added and recorded after the last data in the data stream, and any desired data having k bits (where k is any desired positive integer) may be further recorded after the data having n bits.

The eighth invention is directed to a reproducing apparatus, comprising: a reproducing unit which reproduces signals recorded in a recording medium and outputs reproduction signals; a difference detecting unit which generates differential signals which represent a difference between two consecutive ones of the reproduction signals; a binary data generating unit which generates binary data which are binarized based on the differential signals; and a decoding unit which decodes the binary data by a run length limit encoding scheme.

In an optical disk or the like for example, since a reproduction signal has a large low-frequency skew distortion in a portion where a beam spot of a light beam has just moved from a pre-pit area to a data recording area, it is difficult to binarize a reproduction signal according to a conventional technique.

The reproducing apparatus according to the present invention subtracts two consecutive reproduction signals as they are analog signals for example to thereby generate the differential signal (which is a differential signal between the analog signals), or converts two consecutive reproduction signals into digital signals having a plurality of bits (10-bit data for example) and then generates a differential signal between the two consecutive digital signals having a plurality of bits (which is a differential signal between the plurality of bits). The differential signal is thereafter binarized.

Since the differential signal between the analog signals or the differential signal between the plurality of bits is generated first, even when the reproduction signals contain a skew distortion (a low-frequency waveform distortion), the skew is cancelled and fails to be contained in the differential signal.

The present invention achieves an effect that it is possible to realize a reproducing apparatus which accurately binarizes a reproduction signal without influenced by a skew.

In a conventional reproducing apparatus which reproduces NRZI-converted encoded data for instance, since reproduction signals are binarized and a differential signal between thus binarized two consecutive reproduction signals is generated to thereby execute decoding, a skew is influential.

The present invention achieves an effect that it is possible to realize a reproducing apparatus which accurately binarizes a reproduction signal without influenced by a skew and simultaneously decodes (inverse conversion) an NRZI-converted reproduction signal.

The ninth invention is directed to a reproducing apparatus, comprising: a reproducing unit which reproduces, from a recording medium, encoded data which are encoded by an encoding scheme including a run length limit encoding scheme and recorded as they are divided into a plurality of data blocks; and a decoding unit which, using the encoded data of the data block and the encoded data of the next data block, decodes the encoded data of the data block or the next data block.

The present invention achieves an effect that it is possible to realize a reproducing apparatus which reproduces and decodes encoded data which are recorded in a recording medium at a high effective recording density, owing to continuity between encoded data belonging to each data recording area and encoded data belonging to precedent and subsequent data recording areas.

A conventional reproducing apparatus which uses a run length limit encoding scheme for instance is capable of only reproducing a signal from a recording medium in which recorded within each data recording area is such a data block which permits decoding to finish only within each data block.

The present invention achieves an effect that it is possible to realize a reproducing apparatus particularly for a recording medium in which data covering one sector are divided over a number of data recording areas (For example, recording tracks (each having a length equivalent to one round within a disk) in a disk-shaped recording medium are each divided into 1000 or more data recording areas.) and recorded at a high effective recording density.

The tenth invention is directed to a reproducing apparatus, comprising: a reproducing unit which reproduces and outputs, from each one of a plurality of data recording areas of a recording medium, reproduction signals of data blocks and predetermined data further recorded before the data blocks; a binarizing unit which binarizes the reproduction signals and outputs binary signals; and a decoding unit which combines, in the order of reproduction from the data recording areas, the binary signals of a plurality of the data blocks with each other except for the predetermined data of other data blocks than at least the top data block, and decodes the binary signals thus combined by a run length limit encoding scheme.

The present invention achieves an effect that it is possible to realize a reproducing apparatus which reproduces and decodes encoded data which are recorded in a recording medium at a high effective recording density, as a data stream encoded by a run length limit encoding scheme is divided into a plurality of data blocks and each data block is recorded in each data recording area. As a reproduction signal is binarized using predetermined data as in an embodiment for instance, it is possible to binarize the reproduction signal without influenced by a skew.

The predetermined data is any desired data having one bit or more.

The decoder unit may decode from a binarized signal, excluding the predetermined data other than in at least the data block located at the top, or the binarizing unit may not binarize these predetermined data (The embodiments are the latter.).

The eleventh invention is directed to a reproducing apparatus, comprising: a reproducing unit which reproduces a data stream of encoded data which are encoded by an encoding scheme including a run length limit encoding scheme from a recording medium; a counter which counts the number of encoded data of the data stream, the number of encoding processes or the number of decoded data; a last encoded data detecting unit which detects a last encoded data of the data stream based on the value of the counter; and a decoding unit which, when the last encoded data detecting unit detects that a decoding-target encoded data is the last encoded data, decodes the decoding-target encoded data using at least the decoding-target encoded data and data having a constant value.

In conventional reproducing apparatus which uses an encoding scheme including a run length limit encoding scheme which requires to use subsequent encoded data at the time of decoding, for the purpose of decoding the last encoded data in a data stream, it is necessary to reproduce from a recording medium subsequent encoded data which follows the last encoded data.

The reproducing apparatus according to the present invention decodes the last encoded data using data having a certain value (which are typically data held in the decoder unit) held in the reproducing apparatus.

The present invention achieves an effect that it is possible to realize a reproducing apparatus which decodes a reproduction signal reproduced from a recording medium in which data for decoding the last encoded data are not recorded.

The counter and the last encoded data detector unit may directly count the number of encoded data or the like, or indirectly count the number of encoded data. This virtually includes counting of the number of encoded data of the data stream, the number of encoding processes or the number of decoded data.

This is counting of channel bits one bit or three bits each, for instance. This is to count the number of encoding conversions for example or to count the number of decoded data (the number of clocks).

Since 3-bit encoded data are generated through one encoding conversion, it is possible to calculate the number of encoded data based on counting of the number of encoding conversions by the formula below:

$$\text{The number of encoded data} = 3 \times \text{the number}$$

$$\text{of encoding conversions}$$

In a similar fashion, with respect to encoded data which were encoded by the (1-7) encoding scheme for example, since 2-bit decoded data are generated through decoding of 3-bit encoded data, it is possible to calculate the number of encoded data based on counting of the number of decoded data by the formula below:

$$\text{The number of encoded data} = 1.5 \times \text{the}$$

$$\text{number of decoded data}$$

An example will now be considered that 900 reproduction clocks (clocks for encoded data) are generated per segment (including a pre-pit area), encoded data are reproduced with reference to the 111-st through the 890-th reproduction clocks (The first through 110-th and the 891-st through the 900-th clocks are for areas in which data are not recorded (pre-pit areas).), and the 410-th clock is for the last encoded data (Data are recorded from the 111-st through the 410-th clocks.).

The counter is reset at the 110-th reproduction clock (i.e., becomes zero), and when the value in the counter reaches 300 (the 410-th clock), the last encoded data detector unit detects the last encoded data.

Alternatively, the counter is reset at the 0-th reproduction clock (= the 900th clock) (i.e., becomes zero), and when the value in the counter reaches 410 (the 410-th clock), the last encoded data detector unit detects the last encoded data (Since it is known that there is not encoded data from the first through 110-th clocks, the number of encoded data of a data stream is virtually counted.).

By a method according to the example above or the like, the last encoded data is detected.

The twelfth invention is directed to a recording method, comprising: an encoding step of generating a plurality of data blocks which are obtained by dividing one data stream which is formed by encoded data which are obtained by encoding input data by an encoding scheme including a run length limit encoding scheme; a data adding step of adding data having a predetermined value of at lease one bit to the top of at least one of the divided data blocks and generating a data block which contains thus added data; and a recording step of recording the data block which contains thus added data in the recording medium.

The present invention achieves an effect that it is possible to realize a recording method of recording encoded data in a recording medium at a high effective recording density, owing to continuity between encoded data belonging to each data recording area and encoded data belonging to precedent and subsequent data recording areas.

The present invention achieves an effect that it is possible to realize a recording method of recording encoded data at a high effective recording density and under a run length limit restriction particularly in a recording medium in which one sector is divided into a number of data recording areas (e.g., a disk-shaped recording medium in which a recording track whose length is one round is divided into 1000 or more data recording areas).

The recording method according to the present invention requires to record predetermined data at the beginning of each data recording area. Hence, using the reproducing method according to the present invention, it is possible to accurately binarize a reproduction signal utilizing this as in the reproducing method according to an embodiment for example.

The present invention achieves an effect that it is possible to realize a recording method of recording data which permits accurate binarization of a reproduction signal, owing to use of the added data even when the reproduction signals contain a skew distortion (a low-frequency waveform distortion).

The thirteenth invention is directed to a recording method, comprising: an encoding step of generating a plurality of data blocks which are obtained by dividing one data stream which is formed by encoded data which are obtained by encoding input data by an encoding scheme including a run length limit encoding scheme; a data adding step of adding data having the same value as the last one bit of the encoded data in the data block which is before at least one of the divided data blocks to the top of at least one of the divided data blocks and generates a data block which contains thus added data; and a recording step of recording the data block which contains thus added data in the recording medium.

The present invention achieves an effect that it is possible to realize a recording method of recording data in a recording medium at a high effective recording density, owing to continuity between encoded data belonging to each data recording area and encoded data belonging to precedent and subsequent data recording areas.

The present invention achieves an effect that it is possible to realize a recording method of recording encoded data in a recording medium at a high effective recording density and with a high error correcting capability.

The present invention achieves an effect that it is possible to realize a recording method of recording, in a recording medium data which permit a reproducing apparatus to accurately binarize a reproduction signal which contains a skew distortion (a low-frequency waveform distortion).

The fourteenth invention is directed to the recording method of the twelfth invention, wherein the data block has the encoded data in a data volume which is an integer multiple of 2 if a data volume is converted into a volume of data before being encoded by a run length limit encoding scheme.

Since a data block recorded in a recording medium by the recording method according to the present invention has a data capacity which is an integer multiple of 2 (The capacity of a data block is expressed as an effective data size as it is before encoded by a run length limit encoding scheme.), it is possible to simplify the encoding process of encoding data in units of three channel bits (which correspond to the 2-bit input data) and the decoding process of decoding data in units of three channel bits (and it is possible to simplify processing over a joint between adjacent data blocks in particular).

In addition, it is possible to select the size of a data block in units of two bits which are smaller values than units of eight bits or the like according to a conventional technique.

The present invention achieves an effect that it is possible to realize an inexpensive recording method of recording, in a recording medium, data at a high recording density while avoiding a wasteful use.

The fifteenth invention is directed to the recording method of any one of the twelfth through the fourteenth inventions, wherein at the encoding step or the data adding step, data having a predetermined value of n bits (where n is any desired positive integer) are added after the last piece of the encoded data.

The recording method according to the present invention requires to add data having a constant value (which may be 1 for instance) after the last encoded data in the data stream. Therefore, it is possible to decode the last encoded data, using a reproducing apparatus.

The sixteenth invention is directed to a reproduction method, comprising: a reproducing step of reproducing signals recorded in a recording medium and outputting reproduction signals; a difference detecting step of generating differential signals which represent a difference between two consecutive ones of the reproduction signals; a binary data generating step of generating binary data which are binarized based on the differential signals; and a decoding step of decoding the binary data by a run length limit encoding scheme.

The present invention achieves an effect that it is possible to realize a reproduction method of accurately binarizing a reproduction signal without influenced by a skew.

The seventeenth invention is directed to a reproduction method, comprising: a reproducing step of reproducing, from a recording medium, encoded data which are encoded by an encoding scheme including a run length limit encoding scheme and recorded as they are divided into a plurality of data blocks; and a decoding step of, using the encoded data of the data block and the encoded data of the next data block, decoding the encoded data of the data block or the next encoded data.

The present invention achieves an effect that it is possible to realize a reproduction method of reproducing and decoding encoded data which are recorded in a recording medium at a high effective recording density, owing to continuity between encoded data belonging to each data recording area and encoded data belonging to precedent and subsequent data recording areas.

The present invention achieves an effect that it is possible to realize a reproduction method particularly for a recording medium in which data covering one sector are divided over a number of data recording areas (For example, recording tracks (each having a length equivalent to one round within a disk) in a disk-shaped recording medium are each divided into 1000 or more data recording areas.) and recorded at a high effective recording density.

The eighteenth invention is directed to a reproduction method, comprising: a reproducing step of reproducing and outputting, from each one of a plurality of data recording areas of a recording medium, reproduction signals of data blocks and predetermined data further recorded before the data blocks; a binarizing step of binarizing the reproduction signals and outputting binary signals; and a decoding step of combining, in the order of reproduction from the data recording areas, the binary signals of a plurality of the data blocks with each other except for the predetermined data of other data blocks than at least the top data block, and decoding the binary signals thus combined by a run length limit encoding scheme.

The present invention achieves an effect that it is possible to realize a reproduction method of reproducing and decoding encoded data which are recorded in a recording medium at a high effective recording density, as a data stream encoded by a run length limit encoding scheme is divided into a plurality of data blocks and each data block is recorded in each data recording area.

As a reproduction signal is binarized using predetermined data as in an embodiment for instance, it is possible to binarize the reproduction signal without influenced by a skew.

The nineteenth invention is directed to a reproduction method, comprising: a reproducing step of reproducing, from a recording medium, a data stream of encoded data which are encoded by an encoding scheme including a run length limit encoding scheme; a counting step of counting the number of encoded data of the data stream, the number of encoding processes or the number of decoded data; a last encoded data detecting step of detecting a last encoded data of the data stream based on the value of the counter; and a decoding step of, when the last encoded data detecting unit detects that a decoding-target encoded data is the last encoded data, decoding the decoding-target encoded data while using at least the decoding-target encoded data and data having a constant value.

The present invention achieves an effect that it is possible to realize a reproduction method of decoding a reproduction signal reproduced from a recording medium in which data for decoding the last encoded data are not recorded.

While the novel features of the present invention are those described particularly in the attached claims, the present invention, both in terms of structure and content, will be more apparently understood and evaluated, together with other objects and features, when taken in conjunction with the following detailed description which would be understood with reference to the associated drawings.

BRIEF DESCRIPTION OF DRAWINGS

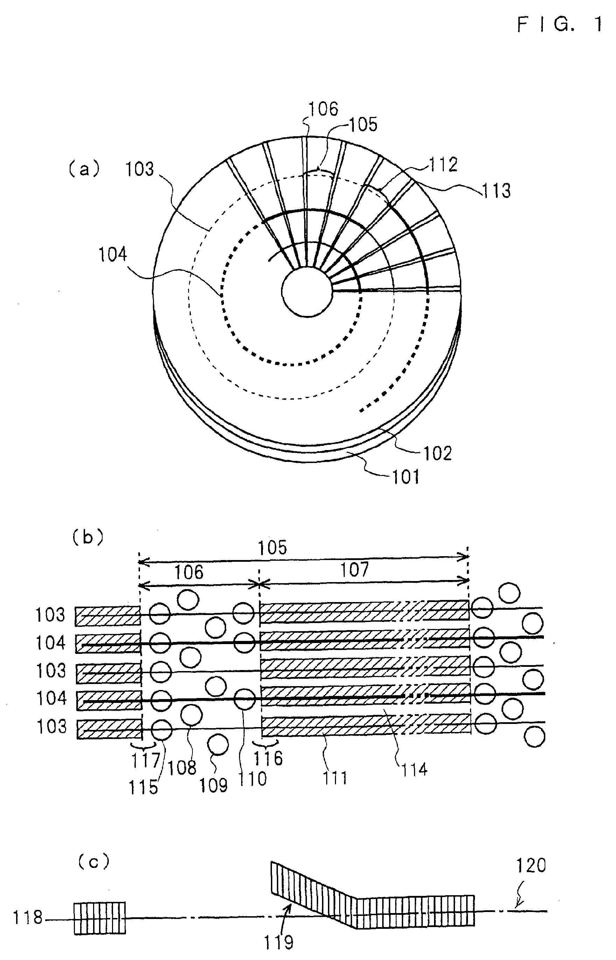

Part (a) of Fig. 1 shows a general overall structure of a magneto-optical disk according to an embodiment of the present invention; part (b) of Fig. 1 is a schematic enlarged view of a segment in the embodiment of the present invention; part (c) of Fig. 1 is a schematic view of the waveform of an analog reproduction signal for data recorded in a segment;

Fig. 2 is a drawing which shows a data zone structure in the magneto-optical disk according to the embodiment of the present invention;

Fig. 3 is a drawing which shows a structure of a recording apparatus for the magneto-optical disk according to the embodiment of the present invention;

Fig. 4 is a drawing which shows a method according to which a write/read control part of a recording apparatus according to the embodiment of the present invention reads out encoded data which are written in a RAM;

Fig. 5 is a timing chart which shows operations of an NRZI convertor;

Fig. 6 is a drawing which shows a structure of an encoder using the (1-7) encoding scheme according to the embodiment of the present invention;

Fig. 7 is a flow chart which shows operations of the encoder using the (1-7) encoding scheme according to the embodiment of the present invention;

Fig. 8 is a drawing which shows a structure of a reproducing apparatus for the magneto-optical disk according to the embodiment of the present invention;

Fig. 9 is a drawing which shows waveforms of the respective portions of a (1-D) computing unit according to the embodiment of the present invention;

Fig. 10 is a drawing which shows a structure of a decoder using the (1-7) encoding scheme according to the embodiment of the present invention;

Fig. 11 is a flow chart which shows operations of the decoder using the (1-7) encoding scheme according to the embodiment of the present invention;

Part (a) of Fig. 12 shows a general overall structure of a conventional magneto-optical disk; and part (b) of Fig. 12 is a drawing which shows a format structure of the conventional magneto-optical disk;

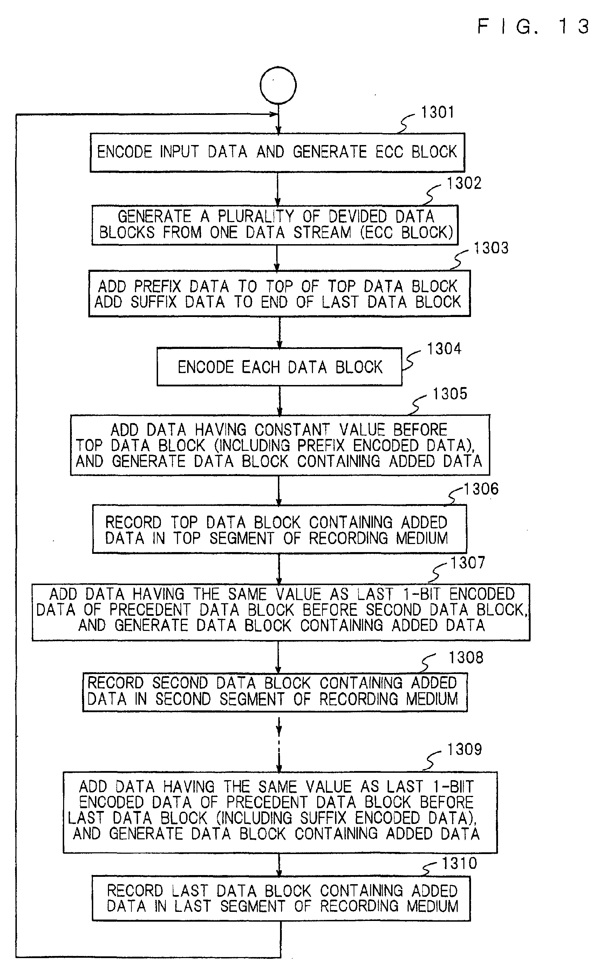

Fig. 13 is a flow chart which shows a recording method for magneto-optical disk according to an embodiment 4;

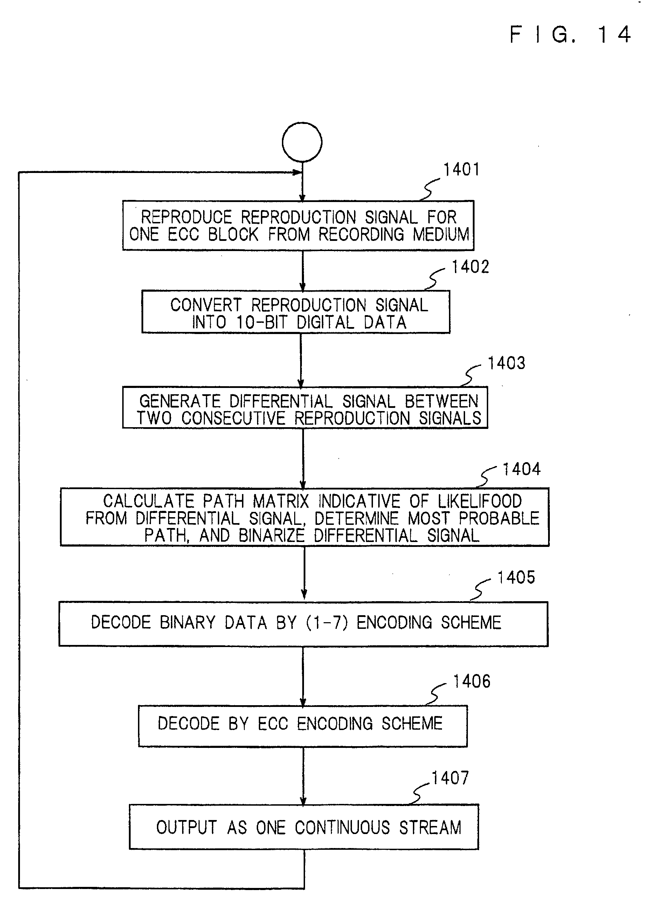

Fig. 14 is a flow chart which shows a reproduction method for magneto-optical disk according to an embodiment 5;

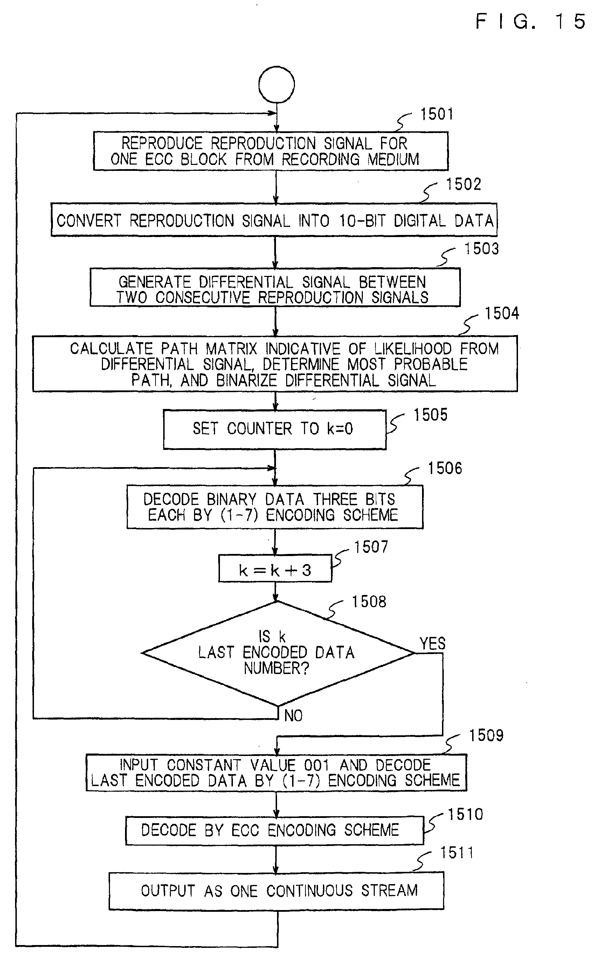

Fig. 15 is a flow chart which shows a reproduction method for magneto-optical disk according to an embodiment 6; and

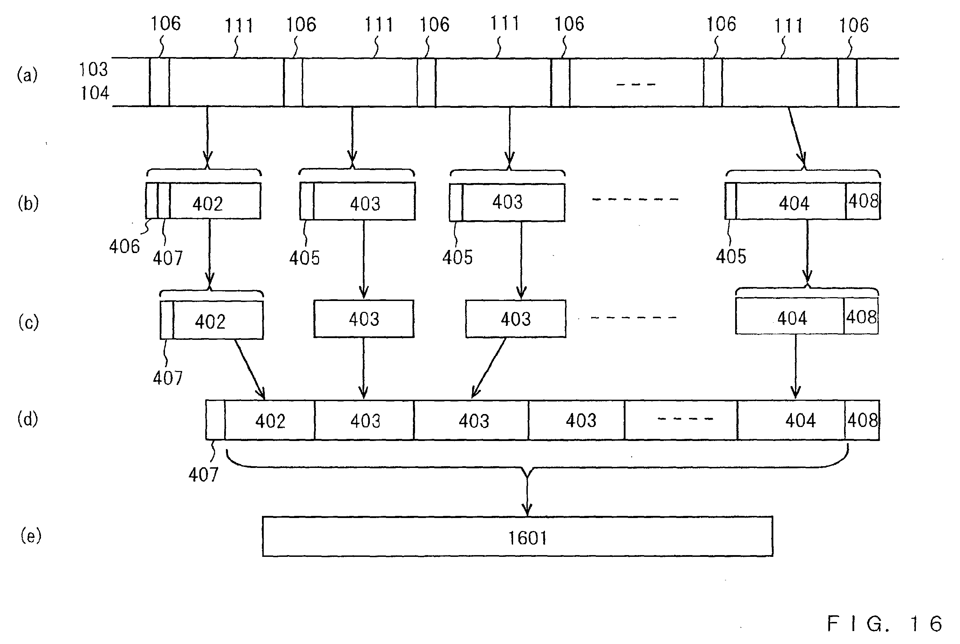

Fig. 16 is a drawing which shows decoding of encoded data in the reproducing apparatus according to the embodiment of the present invention.

It is to be noted that some or all drawings show an overview for the purpose of illustration and do not necessarily depict relative sizes, positions and the like of elements.

BEST MODE FOR CARRYING OUT THE INVENTION

With reference to the associated drawings, embodiments will now be described which are the best mode for implementing the present invention.

<<EMBODIMENT 1>>

An embodiment 1 of the present invention will now be described.

Part (a) of Fig. 1 shows a general overall structure of a magneto-optical disk 100 according to the embodiment 1 of the present invention.

In part (a) of Fig. 1, denoted at is an optical disk substrate, denoted at 102 is a DWDD recording/reproduction film which permits super resolution reproduction, denoted at 103 is a first recording track, denoted at 104 is a second recording track which is adjacent to the first recording track, denoted at 105 are segments obtained by dividing the first recording track 103 and the second recording track 104 into 1280 pieces, denoted at 106 and 113 are pre-pit areas (pre-formatted areas).

The pre-formatted areas 106 and 113 comprise clock pits, servo pits for tracking, and address pits which are indicative of position information regarding a disk.

As shown in the drawing, the first recording track 103 and the second recording track 104 are spiral areas which start and end at the pre-pit areas: When the spiral recording tracks are traced from an inner round toward an outer round of the magneto-optical disk, the second recording track 104 ends at the pre-pit area 113, and the first recording track 103 starts where the second recording track 104 ends (the pre-pit area 113).

In part (a) of Fig. 1, while the magneto-optical disk is a disk whose diameter is about 50 mm, a track pitch of the first recording track 103 and the second recording track 104 is about 0.6μm. In part (a) of Fig. 1 which aims at describing a format structure of the magneto-optical disk, as compared to the size of the magneto-optical disk as a whole, the first recording track 103 and the second recording track 104 which are adjacent to each other are shown as they are extremely enlarged.

Part (b) of Fig. 1 is a schematic enlarged view of one segment 105.

In part (b) of Fig. 1, denoted at 105 is a segment (which is comprised of one recording track and one pre-pit area), denoted at 106 is a pre-pit area (pre-formatted area), and a ditch portion (groove portion) 111 having a length 107 is a recording track (data recording area) for recording data.

The pre-pit area 106 comprises clock pits 115, wobble pits 108 and 109, and address pits 110 in which address information is distributed one bit each at the beginning of a segment.

Inter-ditch portions (land portions) 114 having a length 107 magnetically block adjacent ditch portions from each other.

The clock pits 115 are located at the top of the respective segments. With a frequency-divided signal obtained by dividing an output signal from a voltage controlled oscillator synchronized to a detection signal indicative of the clock pits of the respective segments, it is possible to use the output signal from the voltage controlled oscillator as a synchronization clock for data encoding during recording. The output signal from the voltage controlled oscillator is used also as a synchronization clock for a window clock generation circuit which detects the wobble pits 108 and 109 and the address pits 110.

The paired wobble pits 108 and 109 are located half a track displaced in opposite directions to each other with respect to center lines of the recording tracks 103 and 104, and the polarities of the paired wobble pits 108 and 109 are inverted every round of the recording tracks 103 and 104.

A tracking error signal is generated based on a difference in terms of the amount of reflected light from said wobble pits 108 and 109, and tracking control of a light beam is performed such that the amounts of reflected light from the wobble pits 108 and 109 will be equal to each other.

Whether there are the address pits 110 provides one bit of information per segment. 80 pieces of the address pits 110 gathered together make one piece of position information. The position information expresses a segment position along a track direction and the radius direction on the magneto-optical disk. As for a method of recording such address information, applications regarding a distributed address format (Japanese Patent Application Laid-Open No. 11-021885 and Japanese Patent Application Laid-Open No. 11-329265) describe the details.

A master optical disk is processed by etching with a laser beam, thereby generating a clock pit, two wobble pits, an address pit and a ditch portion on the master disk.

Transferred from a stamper at the time of injection, the clock pit 115, the wobble pits 108 and 109, the address pit 110 and the ditch portion 111 are formed on the optical disk substrate 101. On the optical disk substrate 101 of polycarbonate molded by the injection method, the DWDD recording/reproduction film 102 is formed together with a protection layer by a sputtering method.

The magneto-optical disk according to the present invention formed in this manner comprises the spiral-shaped recording tracks 103 and 104 and the like, the recording tracks 103 and 104 and the like are divided each into 1280 pieces of the segments 105 by the pre-pit areas 106 which are disposed radially (aligned along the radius direction of the magneto-optical disk).

The pre-pit areas 106 in the respective segments are aligned along the radius direction of the magneto-optical disk. Hence, when expressed in angular coordinates whose origin is the center of the magneto-optical disk, the pre-pit areas are located at every 360 degrees / 1280 pieces = 0.28125 degree on the magneto-optical disk, regardless of distances of positions at which the recording tracks are located from the origin.

One segment 105 comprises one pre-pit area 106 and the ditch portion 111 which is one data recording area.

The magneto-optical disk according to the present invention comprises the wobble pits 108 and 109 for tracking in the pre-pit areas 106, and either the wobble pits 108 or 109 are shared by adjacent recording tracks.

Based on such a structure, the first recording track 103 and the second recording track 104 are provided alternately each other which have different tracking polarities (with the wobble pits 108 and 109 respectively located one on the right-hand side and the other on the left-hand side to extension of the recording track in one case, and with the wobble pits 108 and 109 respective located one on the left-hand side and the other on the right-hand side in the opposite manner in other case).

In the data recording areas (the ditch portions 111), encoded data are continuously recorded.

Pre-write portions 116 and post-write portions 117 are formed before and after the data recording areas. Although the pre-write portions 116 and the post-write portions 117 do not guarantee a correct reproduction signal, data having the same values as one bits located at the top of the data recording areas are recorded in the pre-write portions 116 while data having the same values as one bits located at the top of the data recording areas are recorded in the post-write portions 117. In this embodiment, predetermined 1-bit data are recorded at the top of the data recording areas and the pre-write portions 116 as described later.

As described later, this embodiment requires to encode an ECC block by the (1-7) encoding scheme and then execute NRZI-conversion. Encoded data having run length thus generated of 2T through 8T (where T denotes a time length of a channel bit equivalent to one bit) are recorded. However, in some cases, the run length may become 1T (The same values do not appear in a row.) as for the top one bit and the last one bit. A reproduction signal with a run length of 1T has a higher basic frequency than an ordinary reproduction signal whose run length is 2T through 8T, and therefore, may make reproduction difficult.

When the data described above are recorded in the pre-write portion 116 or the post-write portion 117, the run lengths in the top one bit and the last one bit practically become 2T or longer, which in turn makes it possible to correctly reproduce the top one bit and the last one bit without fail.

Part (c) of Fig. 1 schematically shows the waveform of an analog reproduction signal 118 for data which are recorded in the segment 105.

As shown in the drawing, the analog reproduction signal as it is immediately after an optical pick up moves to the ditch portion 111 from the pre-pit area 106 contains a skew (a low-frequency envelope distortion) denoted at 119. Because of this, even when the analog reproduction signal is binarized with reference to a constant level 120 which serves as a threshold value, it is not possible to correctly binarize in the skew portion 119.

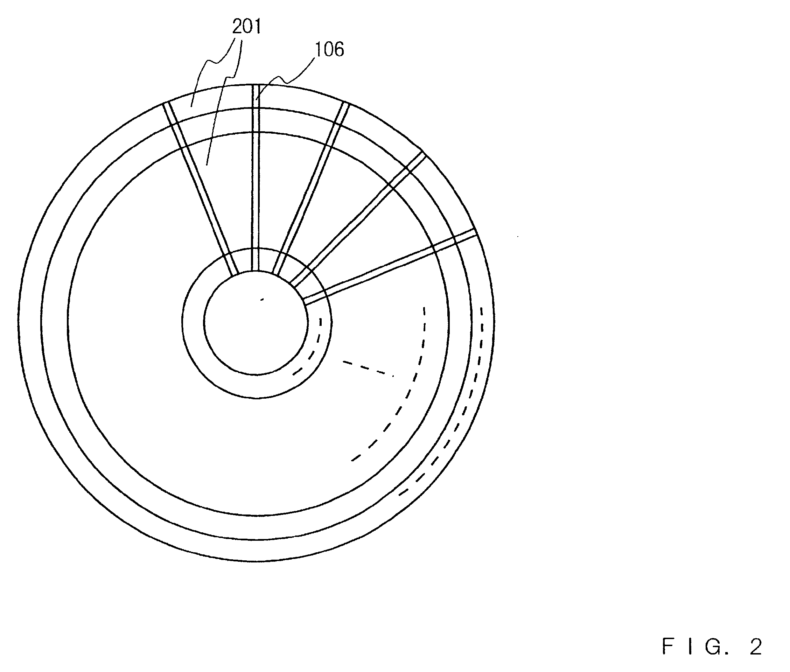

Further, as schematically shown in Fig. 2, the magneto-optical disk according to the embodiment 1 is divided into a plurality of data zones 201 in accordance with a distance along the radius direction.

A constant volume of data are recorded in the respective segments within the same data zone, and as the data zone is closer to the outer round, more data are recorded in the respective segments. Hence, in a recording/ reproduction mode at a constant recording data rate for instance, the magneto-optical disk rotates at a constant angular velocity within the same data zone, but within different data zones, the magneto-optical disk rotates at a slower angular velocity as the data zone is closer to the outer round.

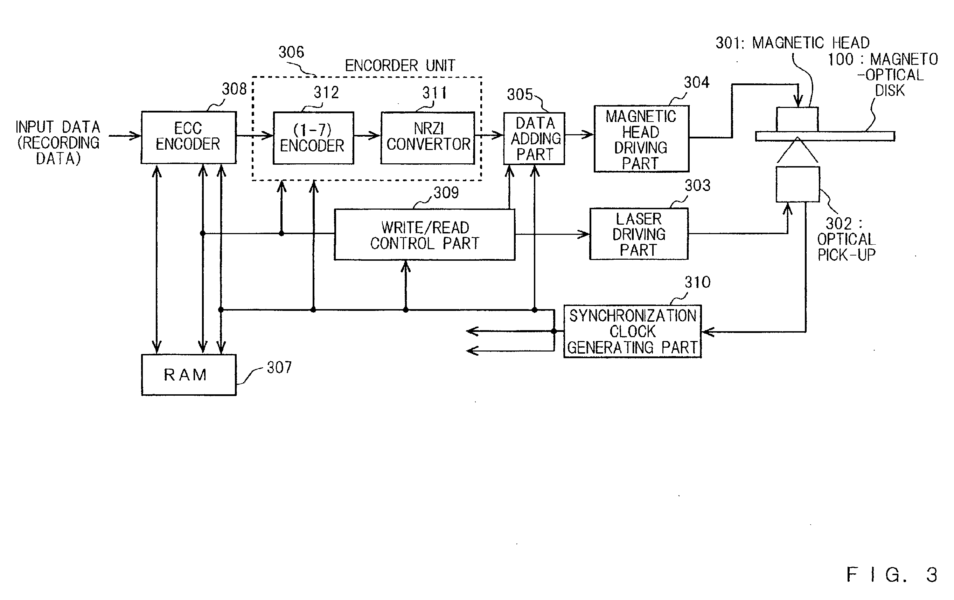

<DESCRIPTION OF RECORDING APPARATUS FOR OPTICAL DISK (FIG. 3)>

Fig. 3 is a drawing which shows a structure of a recording apparatus for the optical disk according to the embodiment 1.

In the drawing, denoted at 100 is the magneto-optical disk, denoted at 301 is a magnetic head, and denoted at 302 is the optical pick-up. The magnetic head 301 and the optical pick-up 302 move on the magneto-optical disk 100, while remaining faced with each other with the magneto-optical disk 100 positioned between the two.

The magneto-optical disk 100 according to this embodiment records and reproduces data by means of laser-pulsed magnetic field modulation. At the time of recording, in a condition that the magnetic head 301 is developing a magnetic field, the optical pick-up 302 irradiates laser light upon the recording film, whereby data are recorded in the magneto-optical disk. At the time of reproduction, with laser light irradiated upon the recording film, reflected light which is polarized along the direction of the magnetic field during recording is detected, whereby signals recorded in the magneto-optical disk are reproduced.

The recording apparatus for the optical disk (a recording unit of an optical disk drive) comprises the magnetic head 301, the optical pick-up 302, an ECC encoder 308 (ECC stands for Error Correction Code), a RAM 307, an encoding unit 306, a data adding part 305, a magnetic head driving part 304, a laser driving part 303, a write/read control part 309 and a synchronization clock generating part 310.

The synchronization clock generating part 310 generates synchronization clocks which serve as a reference during recording, from the clock pits 115 which are formed on the magneto-optical disk 100.

The synchronization clock generating part 310 sends synchronization clocks to the data adding part 305, the write/read control part 309, the encoding unit 306, the ECC encoder, the RAM 307, etc.

The write/read control part 309 receives the synchronization clocks, and controls operations of the ECC encoder 308, the RAM 307, the encoding unit 306, the data adding part 305 and the laser driving part 303.

Input data (recording data) are fed to the ECC encoder 308.

After storing the input data in the RAM 307, the ECC encoder 308 generates an ECC block to which redundancy data are added and in which data are interleaved.

An ECC block is an aggregation of 38336-B data (including 32-kB data and the redundancy data) generated through one ECC encoding process, and is the minimum write/read unit.

A (1-7) encoder and an NRZI convertor are reset for every ECC block, and (1-7) encoding and NRZI conversion are newly started at the top of the ECC blocks.

After (1-7) encoded and NRZI-converted, a new ECC block is recorded (excluding prefix data and the like) starting at the top of a new segment in the recording medium.

The ECC encoder 308 divides and outputs, approximately for each data block, thus generated ECC block.

One data block is converted into encoded data by the encoding unit 306, added to with necessary data by the data adding part, and recorded in one data recording area.

The encoding unit 306 comprises a (1-7) encoder 312 and an NRZI convertor 311.

The (1-7) encoder 312 receives the ECC block outputted from the ECC encoder 308, encodes the ECC block by the (1-7) encoding scheme in synchronization to an encoding clock generated by the synchronization clock generating part 310 (Through conversion, a run length of the ECC block is restricted. That is, the number of zeroes appearing in a row is restricted to the range of 1 through 7.), and outputs encoded data.

As shown in Table 1, encoded data encoded by the (1-7) encoding scheme has a data volume which is 1.5 times as large as that of original data, and therefore, encoded data resulting from one ECC block have a size of about 58 kB (channel bit count).

The write/read control part 309 counts the encoding clocks and identifies the last bit of a data block.

When the write/read control part 309 identifies the last bit of a data block, the (1-7) encoder 312 stops operating after the last bit is outputted, and starts operating again at the timing of starting transmission of the next data block.

As described later, before encoding data representing one ECC block, the encoding unit 306 is set with an initial value (prefix data), and starts encoding at the initial value.

Before outputting an encoded data block located at the top (a top portion of one ECC block), the encoding unit 306 outputs 3-bit prefix encoded data 407 (encoded data having the initial value). Values of the 3-bit prefix encoded data 407 are shown under the INPUT DATA section, 2, "ENCODED DATA OF PREFIX INPUT DATA" section in Table 3 (001 or 010 in accordance with a 2-bit value which is at the top of one ECC block).

The purpose of generating the 3-bit prefix encoded data and recording in the recording medium is to correctly encode the first three bits of the encoded data of one ECC block (The last two bits of precedent encoded data are used. In the embodiment 1, 01 or 10 is used.).

In a similar fashion, the encoding unit 306 additionally receives 2p pieces (where p is a positive integer) of suffix data (which are data representing successive zeroes in the embodiment) after the last data of one ECC block, and after encoding the last data block (the last portion of the ECC block), further encodes the suffix data and outputs suffix encoded data 408.

The ECC encoder 308 stores the suffix data in the RAM 307, and after outputting the last data block, outputs the suffix data following this.

The encoded data outputted from the (1-7) encoder 312 are transmitted to the NRZI convertor 311.

The NRZI convertor 311 is reset before receiving the added data block to one ECC block, and outputs output data 0.

The NRZI convertor 311 receives the encoded data outputted from the (1-7) encoder 312, and outputs NRZI-converted encoded data.

NRZI conversion is an encoding scheme which requires to invert the level of a (0 → 1 or 1 → 1) signal only when the next bit is 1.

Ones do not appear in a row in the encoded data encoded by the (1-7) encoding scheme according to this embodiment, and during operations of the NRZI convertor, an (0 → 1) output is inverted at a rising edge of the data.

In other words, the NRZI convertor 311 starts at an initial value 0 and is inverted from 1 to 0 or from 0 to 1 every time the input data change from 0 to 1.

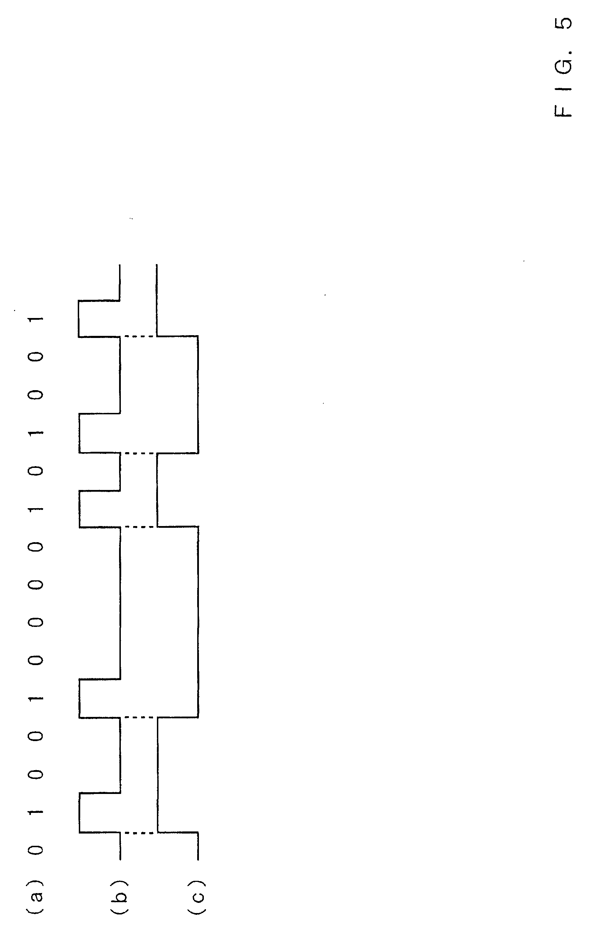

Fig. 5 is a timing chart which shows operations of the NRZI convertor 311.

Numerical values of the input data to the NRZI convertor 311 are shown in part (a) of Fig. 5, and the waveform is shown in part (b) of Fig. 5. In accordance with the input data shown in parts (a) and (b) of Figs. 5, the NRZI convertor 311 outputs output data as that shown in part (c) of Fig. 5.

While a bit rate and an information volume of the NRZI-converted encoded data remain the same as those of the original encoded data (In NRZI-converted encoded data, information exists at a point of level change), the basic frequency is low. Since the basic frequency of the data becomes low, it is possible to record data in the recording medium at a high recording density.

The data adding part 305 receives the prefix encoded data 407 outputted from the NRZI convertor 311 (the encoding unit 306), the data blocks of the encoded data and the suffix encoded data 408, adds constant data 406 (data having five bits in total) and data 405 (data which have four bits in total and are denoted at the reference symbol 409) which have the same value as the encoded data at the last one bit of the precedent data block, both of which will be described later, respectively before the prefix encoded data 407 and the suffix encoded data 408, and outputs thus added data block.

In a similar manner, the data 405 (data which have four bits in total and are denoted at the reference symbol 409) which have the same value as the encoded data in the last one bit are added after the last encoded data of each data block, and the data are outputted.

The data adding part 305 is formed by one D flip-flop for instance. Before starting outputting of the encoded data of the ECC block, the D flip-flop is reset and outputs zero.

Before loading the prefix encoded data 407 and outputting, the data adding part 305 outputs zero (the constant data 406) for a 5-clock period. A 4-clock period corresponds to the pre-write portion 116. Data recorded during the last 1-clock period are top effective data which are recorded in the data recording area.

In addition, after the encoded data of each data block or the suffix encoded data 408 are loaded and outputted, the data 405 having the same value as the encoded data at the last one bit of each data block or the suffix encoded data 408 are held. Following the last encoded data of each data block, the data 405 are outputted for a 4-clock period (The 4-clock period corresponds to the post-write portion 117. These four bits are illustrated as they are included in the symbol 408.).

During a period in which the optical pick-up moves over the pre-pit area, the data adding part 305 holds the data 405 (excluding after outputting the suffix encoded data 408).

Before the next data block is loaded and outputted, the data 405 are outputted further for a 5-clock period. A 4-clock period corresponds to the pre-write portion 116. Data recorded during the last 1-clock period are top effective data which are recorded in the data recording area.

The function of the data adding part 305 described above is easily executed by means of clock control.

In other embodiments, the data adding part 305 is integrated with the NRZI convertor 311.

The magnetic head driving part 304 receives the added data block from the data adding part 305, and energizes the magnetic head 301 with a current which is in accordance with each piece of the encoded data in the added data block. The magnetic head 301 develops a magnetic field which is in accordance with this current.

When the magnetic head driving part 304 energizes the magnetic head 301 with a current, the write/read control part 309 transmits to the laser driving part 303 pulses having the same pitches (constant pitches) as bit pitches of each piece of the encoded data (channel bits). The laser driving part 303 outputs laser light having said constant pitches, and the laser light heats up the recording film of the magneto-optical disk via the optical pick-up 302. As a result, the encoded data (channel bits) are recorded in the recording film.

In this manner, the data blocks containing the added data are recorded in the data recording areas in the respective segments of the magneto-optical disk 100.

In the magneto-optical disk according to the embodiment 1, a channel bit count recordable in each data recording area is different between the data zones, and the recording capacity increases as the data zone is closer to the outer round.

It is possible to record data having 468 bits (when expressed as the number of data before encoding by the (1-7) encoding scheme) in one segment within the inner-most data zone and record data having 986 bits in one segment within the outer-most data zone.

It is possible to record one ECC block, with the ECC block divided into the number of segments which is calculated as TRUNC (8 · Q / N) + 1, where a channel bit count of one ECC block is Q bytes and a channel bit count recordable in the data recording area of each segment is N bits (TRUNC denotes a function for outputting a value which is obtained by rounding down decimal figures of a calculated value in the parentheses.).

According to rough calculation, in the inner-most data zone, one ECC block is recorded over 656 segments, according to TRUNC (8 bits × (32 kB + 5088 + 480) / 468) + 1 = 656. In the outer-most data zone, one ECC block is recorded over 312 segments, according to TRUNC (8 bits × (32 kB + 5088 + 480) / 986) + 1 = 312 (5088 bytes and 480 bytes are redundancy data of the ECC block.).

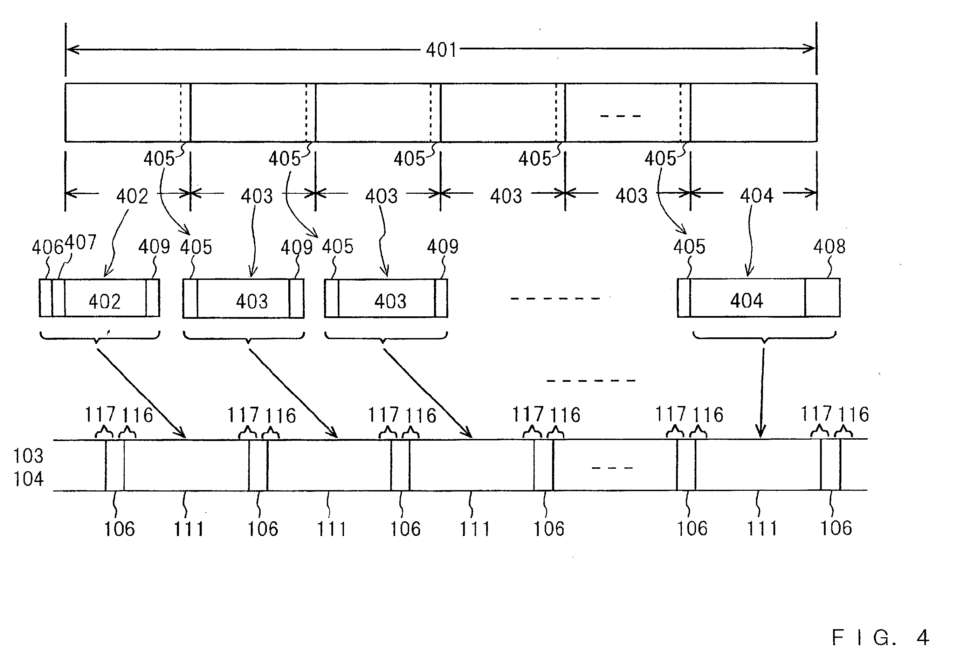

<DESCRIPTION OF WRITE/READ CONTROL PART (FIG. 4)>

Fig. 4 shows a method according to which the ECC encoder 308 reads out an ECC block written in the RAM 307, the encoding unit 306 encodes the ECC block and the data adding part 305 adds predetermined data to a data block.

The ECC encoder 308 writes one ECC block and suffix data (The data are data of repeated 00. Encoded by the (1-7) encoder 312, the data become the 3-bit suffix encoded data 408 (which are data of repeated 001) having 2p bits (where p is a positive integer) in the RAM 307.

The ECC encoder 308 reads a data block (which will become the first data block 402 after encoded) of data recorded in the top segment within one ECC block 401, from the RAM 307.

Before starting encoding of an ECC block, the (1-7) encoder 312 is set to an initial value as described later.

The (1-7) encoder 312 encodes the initial value to thereby generate and output the 3-bit prefix encoded data 407, and receives the first data block to be inputted, encodes the first data block to thereby generate and output the first data block 402 which is formed by the encoded data.

The data adding part 305 receives the 3-bit prefix encoded data 407 and the first data block 402, adds the constant data 406 having five bits (The data may be two bits or more. The data are all zero in the embodiment 1.) to the top of these encoded data, adds the 4-bit data 409 which have the same value as the data 405 in the last one bit of the data block 402 after the data block 402, and outputs the first data block which contains the added data.

The first four bits of the 5-bit constant data 406 are recorded in the pre-write portion 116. The added first data block, which is formed by the last one bit of the 5-bit constant data 406, the 3-bit prefix encoded data 407 and the first data block 402, is recorded in the data recording area within the first segment 111.

Although not being effective encoded data, these first four bits recorded in the pre-write portion 116 prevent the run length of the 1-bit constant data 406 from becoming 1T and accordingly guarantee the run length of 2T or longer.

Further, the data adding part 305 stores the value of the last piece of the encoded data 405 in the first data block 402.

Even after outputting the first added data block (including the last piece of the encoded data 405), the data adding part 305 keeps outputting the last piece of the encoded data 405 of the first data block 402 further for a 4-bit period (409. Only one bit or more needs be contained.). The 4-bit data 409 are recorded in the post-write portion 117.

Although not being effective encoded data, these four bits recorded in the post-write portion 117 prevent the run length of the last piece of the encoded data 405 of the first data block 402 from becoming 1T and accordingly guarantee the run length of 2T or longer.

The formula below holds satisfied in the embodiment 1.

One channel bit (constant data 406) + three

channel bits (prefix encoded data 407) + the channel

bit count of the first data block 402 = the channel

bit count of the data area within one segment

In an optical disk drive which needs a constant period of time until a laser light output stabilizes after the start of recording, the data adding part 305 outputs a header portion having a constant data length (a 32-bit data string having the value 0 for instance) and a Sync portion having a constant data length (a synchronizing portion), the 3-bit prefix encoded data 407. These data are recorded in the first segment 111.

The data length of the header portion is determined so that a recording time for the header portion will be longer than a period of time needed for a laser light output to stabilize after the start of recording. This makes it possible to guarantee the reliability of a reproduction signal for data following the header portion.

The Sync portion is a known signal for byte synchronization of a data string which follows the header portion. This is 8-bit data which may be 11110000 for example.

Next, the ECC encoder 308 reads a data block (which will become the second data block 403 after encoded) of data recorded in the second segment within one ECC block 401, from the RAM 307.

The (1-7) encoder 312 encodes the data block of the data which are to be recorded in the second segment, and generates and outputs the second data block 403 (which is formed by the encoded data). When the (1-7) encoder 312 (1-7) encodes the data located at the top of the second data block, subsequent 2-bit data and the last 1-bit data of the first data block are used. In other subsequent data blocks as well, when the top data in each data block are (1-7) encoded, subsequent 2-bit data and the last 1-bit data of the immediately precedent data block are used. Thus, in a practical sense, the stream (which is the ECC block in the embodiment) as a whole is (1-7) encoded (without any break), and the data blocks obtained by dividing the stream are recorded over the plurality of segments.

The data adding part 305 receives the second data block 403, adds 5-bit data (which only need to contain two bits or more) having the same value as the last piece of the encoded data 405 of the first data block 402 to the top of the second data block 403, adds the 4-bit data 409 having the same value as the encoded data 405 in the last one bit of the data block 403 after the data block 403, and accordingly generates a second data block which contains the added data.

As described above, the data adding part 305 stores the last piece of the encoded data 405 of the first data block 402.

The first four bits within the 5-bit data having the same value as the last piece of the encoded data 405 of the first data block 402 are recorded in the pre-write portion 116. The second data block, which is formed by the last one bit of the 5-bit data having the same value as the last piece of the encoded data 405 of the first data block 402 and the added data which are formed by the second data block 403, is recorded in the data recording area within the second segment 111.

Although not being effective encoded data, these first four bits recorded in the pre-write portion 116 prevent the run length of the 1-bit data added at the top and having the same value as the last piece of the encoded data 405 of the first data block 402 from becoming 1T and accordingly guarantee the run length of 2T or longer.

Further, the data adding part 305 stores the value of the last piece of the encoded data 405 in the second data block 403.

Even after outputting the second added data block 403 (including the last piece of the encoded data 405), the data adding part 305 keeps outputting the last piece of the encoded data 405 of the second data block 403 further for a 4-bit period (409. Only one bit or more needs be contained.). The 4-bit data 409 are recorded in the post-write portion 117.

Although not being effective encoded data, this 4-bit data recorded in the post-write portion 117 prevent the run length of the last piece of the encoded data 405 of the second data block 403 from becoming 1T and accordingly guarantee the run length of 2T or longer.

The formula below holds satisfied in the embodiment 1.

One channel bit (encoded data 405) + the channel bit count of the second data block 403 = the channel bit count of the data area within one segment

Next, the ECC encoder 308 reads a data block (which will become the third data block 403 after encoded) of data recorded in the third segment within one ECC block 401, from the RAM 307.

The (1-7) encoder 312 encodes the data block which is to be recorded in the third segment, and generates and outputs the third data block 403 (which is formed by the encoded data). As described above, when the (1-7) encoder 312 (1-7) encodes the data located at the top of the third data block, subsequent 2-bit data and the last 1-bit data of the second data block are used.

The data adding part 305 receives the third data block 403, adds 5-bit data (which only need to contain two bits or more) having the same value as the last piece of the encoded data 405 of the second data block 403 to the top of the third data block 403, adds the 4-bit data 409 having the same value as the last data 405 of the last one bit of the third data block 403 after the data block 403, and accordingly generates a third data block which contains the added data.

As described above, the data adding part 305 stores the last piece of the encoded data 405 of the second data block 403.

The first four bits within the 5-bit data having the same value as the last piece of the encoded data 405 of the second data block 403 are recorded in the pre-write portion 116. The third data block, which is formed by the last one bit of the 5-bit data having the same value as the last piece of the encoded data 405 of the second data block 403 and the added data which are formed by the third data block 403, is recorded in the data recording area within the third segment 111.

Although not being effective encoded data, these first four bits recorded in the pre-write portion 116 prevent the run length of the 1-bit data added at the top and having the same value as the last piece of the encoded data 405 of the second data block 403 from becoming 1T and accordingly guarantee the run length of 2T or longer.

Further, the data adding part 305 stores the value of the last piece of the encoded data 405 in the third data block 403.

Even after outputting the added third data block 403 (including the last piece of the encoded data 405), the data adding part 305 keeps outputting the last piece of the encoded data 405 of the third data block 403 further for a 4-bit period (409. Only one bit or more needs be contained.). The 4-bit data 409 are recorded in the post-write portion 117.

Although not being effective encoded data, these four bits recorded in the post-write portion 117 prevent the run length of the last piece of the encoded data 405 of the third data block 403 from becoming 1T and accordingly guarantee the run length of 2T or longer.

The formula below holds satisfied in the embodiment 1.

One channel bit (encoded data 405) + the channel bit count of the third data block 403 = the channel bit count of the data area within one segment

This will be thereafter repeated.

Since the (1-7) encoding scheme requires to input 2-bit data and output 3-bit encoded data (the number of channel bits), each data block (such as 402) preferably contains data whose volume, if converted into a data volume as it is before encoded by the (1-7) encoding scheme, is an integer multiple of 2. This allows to simplify a control circuit for a clock signal for the encoding unit 306, etc.

In the embodiment 1, when data are to be recorded in the inner-most data zone for instance, the capacity of the data block is 468 bits, while when data are to be recorded in the outer-most data zone for instance, the capacity of the data block is 986 bits, both of which being an integer multiple of 2 (The capacity of a data block is expressed as an effective data size as it is before encoded by a run length limit encoding scheme.).

The capacity of the data recording area in each segment does not need to be an integer multiple of eight bits (as expressed as a pre-encoding effective data size), but may be any chosen length as far as being integer multiple of 2 to thereby realize recording without a wasteful use.

A method will now be described of recording the last piece of data of one ECC block 401 in the last segment.

The last segment usually comprises a remainder area. The constant data (predetermined data) 408 are recorded in the remainder area.

Hence, as for the last piece of data of last segment, it is possible to establish encoding and decoding by the (1-7) encoding scheme, utilizing the known data in the next remainder area.

Next, the ECC encoder 308 reads a data block (which will become the last data block 404 after encoded) of data recorded in the last segment within one ECC block 401 and constant data (The data are repeated 00 (an even number of zeroes) in this embodiment. When encoded, the data become the constant encoded data 408.), from the RAM 307.

The (1-7) encoder 312 encodes the data block which is to be recorded in the last segment to thereby generate the last data block 404 formed by the encoded data, encodes constant data (repeated 00) to thereby generate the constant encoded data 408 (repeated 001), and outputs these data.

The data adding part 305 receives the last data block 404 and the constant encoded data 408, adds 5-bit data (which only need to contain two bits or more) having the same value as the last piece of the encoded data 405 of the second last data block 403 to the top of the last data block 404, and accordingly generates the last data block which contains the added data.

As described above, the data adding part 305 stores the last piece of the encoded data 405 of the second last data block 403.

The first four bits within the 5-bit data having the same value as the last piece of the encoded data 405 of the second last data block 403 are recorded in the pre-write portion 116 of the last segment 111. The last data block, which is formed by last one bit of the 5-bit data having the same value as the last piece of the encoded data 405 of the second last data block 403, the last data block 404, and the last added data which are formed by the constant encoded data 408, is recorded in the data recording area within the last segment 111.

Although not being effective encoded data, these first four bits recorded in the pre-write portion 116 prevent the run length of the 1-bit data added at the top and having the same value as the last piece of the encoded data 405 of the second last data block 403 becoming 1T and accordingly guarantee the run length of 2T or longer.

The constant encoded data 408 are determined so as to have such a channel bit count which satisfies the recording capacity of the last data recording area 111. It is preferable that about four bits are recorded in the post-write portion 117 beyond the last data recording area 111.

Although not being effective encoded data, these four bits recorded in the post-write portion 117 prevent the run length of the last piece of the encoded data 405 of the third data block 403 from becoming 1T and accordingly guarantee the run length of 2T or longer.

In the embodiment 1, the constant data 408 are data in which 3-bit value 001 repeatedly appears (which may be 001001... for instance). The 3-bit value 001 is encoded data of a situation that values of data which is an encoding target and the next data following this encoding target data are all 00 (See Table 1.).

The channel bit count of the constant data 408 is calculated from the following formula:

(The channel bit count of the constant data

408) = (The channel bit count of the data area within

one segment) - (The channel bit count of the last data

block 404) - one bit + four bits

The term "- one bit" in the formula above denotes the last 1-bit encoded data 405 added to the top.

The term "+ four bits" means the 4-bit recorded in the post-write portion 117.

The magneto-optical disk according to the embodiment 1 comprises the plurality of data zones and a different number of data are recorded in one segment, and therefore, the number of data of the constant data 408 is different between the different zones.

The number of data of the constant data 408 is at least two bits or more, and in the event that the number of data of the constant data 408 calculated from the formula above is zero or one, one segment is further added to this ECC block. the encoded data 405 located at the last one bit of the precedent segment are recorded at the top of thus added one segment, and the constant data 408 (the continuation of the constant data 408 recorded in the precedent segment) are written after this.

As described above, the recording apparatus encodes one ECC block 401 and divides the same into a plurality of data blocks which are to be recorded in segments, adds 1-bit (in terms of the number of effective data) data at the top of each data block, and records the 1-bit data and the data blocks in the recording medium when the optical pick-up 302 moves over the data recording areas.

According to the embodiment, data (predetermined data) having the same value as the last encoded data of a data block within an immediately precedent data recording area are recorded at the top of a data recording area of the recording medium. Instead of this, any desired data (predetermined data) having one bit or more may be recorded at the top of each data recording area. For instance, data which are the same as any desired data added to the pre-write portion or the post-write portion, or alternatively, constant data of 1 or 0 may be recorded at the top of each data recording area.

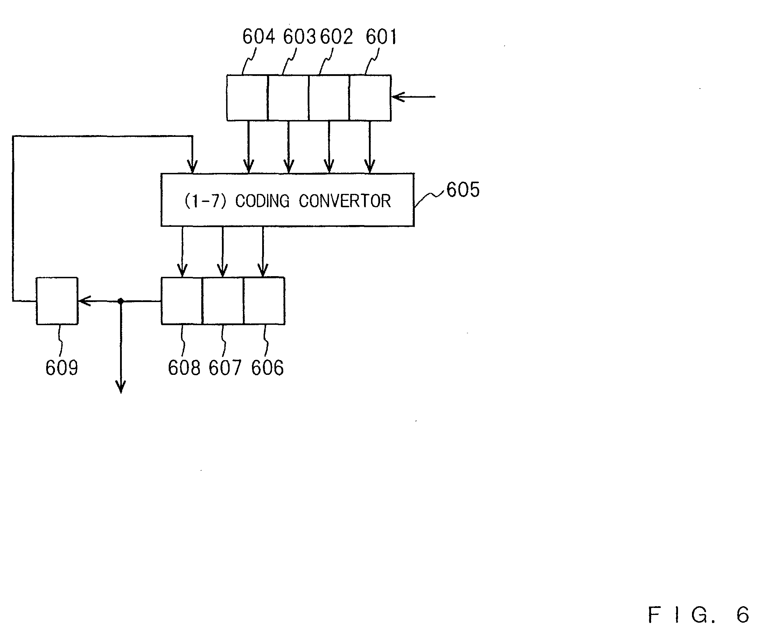

<DESCRIPTION OF STRUCTURE OF (1-7) ENCODER (FIG. 6)>

Fig. 6 shows a structure of the (1-7) encoder 312.

D flip-flops (D-FF) 601, 602, 603 and 604 are serial input parallel output shift registers over four stages, and shift input data from the (1-7), encoder 312 received at a D-input terminal of the D flip-flop 601 and individually output in parallel.

A (1-7) coding convertor 605 receives output signals from the D flip-flops 603 and 604 (2-bit data which are an encoding target), output signals from the D flip-flops 601 and 602 (2-bit data which are the next encoding target) and an output signal from a D flip-flop 609 (the last one bit of encoded data which were encoded immediately before), and outputs 3-bit encoded data in accordance with a conversion rule shown in Table 1.

A structure of the (1-7) coding convertor 605 may be any desired structure.

For example, the (1-7) coding convertor 605, owing to a gate circuit structure, generates output signals based on the input signals. In other embodiments, the (1-7) coding convertor 605 is formed by a ROM, receives the input signals at read address terminals of the ROM, and reads output signals from the ROM at addresses designated by the input signals fed to the address terminals.

D flip-flops 606, 607, 608 and 609 are parallel input serial output shift registers over four stages, shift encoded data received at D-input terminals of the D flip-flops 606, 607 and 608 (the output signals from the (1-7) coding convertor 605), and output at output terminals of the D flip-flops 608 and 609.

An output signal from the D flip-flop 608 (encoded data) is the output signal from the (1-7) encoder 312.

An output signal from the D flip-flop 609 (encoded data) is fed to the (1-7) coding convertor 605.

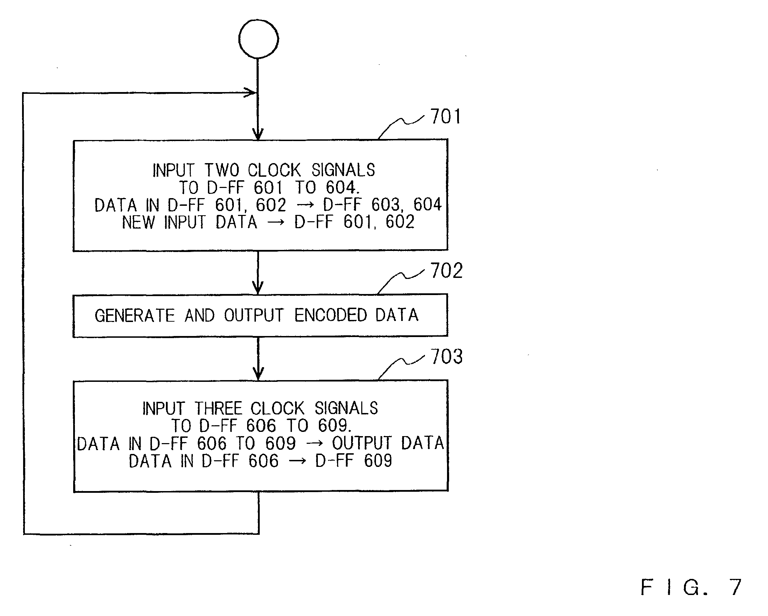

<DESCRIPTION OF OPERATIONS OF (1-7) ENCODER (FIG. 7)>

Fig. 7 is a flow chart which shows operations of the (1-7) encoder 312.

First, two clock signals are fed to the D flip-flops 601, 602, 603 and 604, signals already in the D flip-flops 601 and 602 are transferred to the D flip-flops 603 and 604, and new 2-bit input data are loaded in the D flip-flops 601 and 602 (Step 701).

Next, the (1-7) coding convertor 605 receives output signals from the D flip-flops 601, 602, 603, 604 and 609, generates 3-bit encoded data in accordance with the conversion rule shown in Table 1, and outputs (Step 702). This encoded data are encoded data of data loaded in the D flip-flops 603 and 604.

Next, at a step 703, output signals from the (1-7) coding convertor 605 are loaded in the D flip-flops 606, 607, 608 and 609, these D flip-flops receive three clock signals and shift thus loaded data. Three pieces of encoded data in the D flip-flops 606, 607 and 608 are serially outputted. The last one bit of encoded data in the D flip-flop 606 is transferred to the D flip-flop 609.

The steps 701 through 703 described above are repeated.

When the 2-bit data at the end of the data block recorded in each segment are encoded, the last 2-bit data are loaded in the D flip-flops 603 and 604, the last one bit of encoded data which were encoded immediately before is loaded in the D flip-flop 609, the 2-bit data at the top of the next segment are loaded in the D flip-flops 601 and 602, and encoding is performed. That is, using the data in the data blocks in two adjacent segments, encoding is executed by the (1-7) encoding scheme.

As the last one bit of the data block is outputted, the (1-7) encoder 312 stops operating.

The optical pick-up moves to the next segment, and as timing for generating encoded data to be recorded in the next segment comes, the (1-7) encoder 312 starts operating again.

When the 2-bit data at the top of the data block recorded in each segment are encoded, the operations may be resumed in the condition that the last encoding process of the precedent segment has completed. The top 2-bit data loaded in the D flip-flops 601 and 602 are transferred to the D flip-flops 603 and 604, and subsequent 2-bit data loaded in the D flip-flops 601 and 602, the last one bit of the last encoded data of the data block recorded in the immediately precedent segment is loaded in the D flip-flop 609, and encoding is performed.

As described above, control of the clock signals makes it possible to easily execute encoding of 2-bit data at the end of the data block to be recorded in each segment and 2-bit data at the top of the data block to be recorded in the next segment.

Encoding of a top data of data of an ECC block signal will now be described with reference to Table 3.

According to a run length limit encoding scheme such as the (1-7) encoding scheme, it is not possible to uniquely determine encoded data only with data which are an encoding target. According to the (1-7) encoding scheme, encoded data are determined by data which are an encoding target, precedent encoded data and data which are the next encoding target.

In a similar fashion, according to a run length limit encoding scheme such as the (1-7) encoding scheme, it is possible to correctly encode encoded data using data which are an encoding target and precedent and subsequent encoded data.

In the embodiment 1, with prefix 3-bit encoded data generated and recorded, it is possible to correctly encode and decode a top data of data of one ECC block.

Table 3 shows encoding of a top data of data of one ECC block. Table 3 shows particular data as they are encoded in accordance with Table 1.

EP 1 324 336 A1

Since there are no data before a top data of data of one ECC block, prefix data are added and encoding is

TABLE 3

TABLE OF ENCODED DATA OF TOP INPUT DATA

| NO. | INPUT DATA | | | | | OUTPUT DATA | | |
|---|---|---|---|---|---|---|---|---|
| | 0 | 1 | 2 | 3 | 4 | 1 | 2 | 3 |
| | LAST BIT OF IMAGINARY ENCODED DATA GENERATED IMMEDIATELY BEFORE | INPUT DATA PRECEDENT TO PREFIX INPUT DATA | PREFIX INPUT DATA | TOP INPUT DATA TO BE ENCODED | SUBSEQUENT INPUT DATA | ENCODED DATA OF INPUT DATA PRECEDENT TO PREFIX INPUT DATA | ENCODED DATA OF PREFIX INPUT DATA | ENCODED DATA OF TOP INPUT DATA |
| 1 | 1 | 00 | 00 | 00 | 0X | 001 | 001 | 001 |
| 2 | 1 | 00 | 00 | 00 | 1X | 001 | 001 | 010 |
| 3 | 1 | 00 | 00 | 01 | 00 | 001 | 001 | 010 |
| 4 | 1 | 00 | 00 | 01 | NOT 00 | 001 | 001 | 000 |
| 5 | 1 | 00 | 00 | 10 | 0X | 001 | 010 | 101 |
| 6 | 1 | 00 | 00 | 10 | 1X | 001 | 010 | 010 |
| 7 | 1 | 00 | 00 | 11 | 00 | 001 | 010 | 010 |
| 8 | 1 | 00 | 00 | 11 | NOT 00 | 001 | 010 | 100 |

(X DENOTES 0 OR 1)

26

started.

To be more specific, before starting encoding of the data of one ECC block, the D flip-flops 601 through 604 and 609 are initialized.

In the embodiment 1, considering that encoding of data of 2-bit data 00 appearing infinitely in a row generates encoded data of 3-bit data 001 appearing infinitely in a row, the D flip-flops 601 through 604 are set to zero and the D flip-flop 609 is set to one (which corresponds to the last one bit of the encoded data 001).

The steps 701 through 703 are executed, thereby generating the first piece of encoded data. Encoded data (001) of the data 00 loaded in the D flip-flops 603 and 604 (the INPUT DATA section, 1, " INPUT DATA PRECEDENT TO PREFIX INPUT DATA" in Table 3) are loaded in the D flip-flops 606 through 608 and outputted (the OUTPUT DATA section, 1, "ENCODED DATA OF INPUT DATA PRECEDENT TO PREFIX INPUT DATA" in Table 3). However, this encoded data (which are entirely 001) are not used.

The steps 701 through 703 are executed, thereby generating the second piece of encoded data. First, the data 00 loaded in the D flip-flops 601 and 602 (the INPUT DATA section, 2, "PREFIX INPUT DATA" in Table 3) are transferred to the D flip-flops 603 and 604, and 2-bit data at the top of the data of one ECC block (the INPUT DATA section, 3, "TOP INPUT DATA TO BE ENCODED" in Table 3) are loaded in the D flip-flops 601 and 612.

The last one bit of the encoded data (001) is loaded in the D flip-flop 609.

The data loaded in the D flip-flops 601 through 604 and 609 are fed to the (1-7) coding convertor 605 (the INPUT DATA section, 2, "PREFIX INPUT DATA" in Table 3), and the encoded data are outputted.

The encoded data are loaded in the D flip-flops 606 through 608 and outputted (the OUTPUT DATA section, 2, "ENCODED DATA OF PREFIX INPUT DATA" in Table 3). This encoded data are referred to as the prefix data 407 and become 001 or 010 in accordance with subsequent data (2-bit data at the top of the data of one ECC block). The prefix encoded data 407 are necessary for decoding of the 2-bit data at the top of the data of one ECC block, and therefore, recorded in the recording medium.

The steps 701 through 703 are executed, thereby generating the third piece of encoded data. The 2-bit data at the top of the data of one ECC block previously loaded in the D flip-flops 601 and 602 (the INPUT DATA section, 3, "TOP INPUT DATA TO BE ENCODED" in Table 3) are transferred to the D flip-flops 603 and 604, and subsequent 2-bit data of one ECC block (the INPUT DATA section, 4, "SUBSEQUENT INPUT DATA" in Table 3) are loaded in the D flip-flops 601 and 602.

The (1-7) coding convertor 605 receives the data loaded in the D flip-flops 601 through 604 and 609 (The last one bit of the encoded data is loaded in the D flip-flop 609.), and outputs the encoded data.

The encoded are loaded in the D flip-flops 606 through 608 and outputted (the OUTPUT DATA section, 3, "ENCODED DATA OF TOP INPUT DATA" in Table 3). This encoded data are recorded in the recording medium. This will be then repeated.

Table 5 shows decoding of a top encoded data of the encoded data of one ECC block which are the output data shown in Table 3. Table 5 will be. described in detail in relation to the (1-7) encoder.

In a similar fashion, since there are no subsequent data to the last piece of the data of one ECC block, constant data (which are 00 in the embodiment 1) are added after this and encoding is performed.

Table 4 shows encoding of the last piece of the data of one ECC block. Table 4 shows particular data as they are encoded in accordance with Table 1.

To be more specific, at the time of transfer of the last piece of the data of one ECC block loaded in the D flip-flops 601 and 602 (the INPUT DATA section, 1, "LAST INPUT DATA TO BE ENCODED" in Table 4) to the D flip-flops 603 and 604, suffix data 00 read from the RAM 307 (the INPUT DATA section, 2, "SUFFIX INPUT DATA 1" in Table 4) are loaded in the D flip-flops 601 and 602.

Table 4

TABLE OF ENCODED DATA OF LAST INPUT DATA

| NO. | INPUT DATA | | | | OUTPUT DATA | | |
|---|---|---|---|---|---|---|---|
| | 0 LAST BIT OF ENCODED DATA GENERATED IMMEDIATELY BEFORE | 1 LAST INPUT DATA TO BE ENCODED | 2 SUFFIX INPUT DATA 1 | 3 SUFFIX INPUT DATA 2 | 1 ENCODED DATA OF LAST INPUT DATA | 2 ENCODED DATA OF SUFFIX INPUT DATA 1 | 3 ENCODED DATA OF SUFFIX INPUT DATA 2 |
| 1 | X | 00 | 00 | 00 | 001 | 001 | 001 |
| 2 | 0 | 01 | 00 | 00 | 001 | 001 | 001 |
| 3 | 1 | 01 | 00 | 00 | 010 | 001 | 001 |
| 4 | 0 | 10 | 00 | 00 | 101 | 001 | 001 |
| 5 | 0 | 11 | 00 | 00 | 010 | 001 | 001 |

(X DENOTES 0 OR 1)

Loading of the last data in the D flip-flops 601 and 602 or transfer to the D flip-flops 603 and 604 is detected as a counter incorporated in the (1-7) encoder 312 counts the number of input data (input clock count), the number of encoded data which are outputted, the number of executed data conversions or the like.

The last encoded data of the data of one ECC block loaded in the D flip-flops 603 and 604 is loaded to the D flip-flops 606 through 608 and outputted (the OUTPUT DATA section, 1, "ENCODED DATA OF LAST INPUT DATA" in Table 4). This encoded data are recorded in the recording medium.

After the last piece of the data of one ECC block is encoded, the steps 701 through 703 are executed once again and encoded data are accordingly generated. The 2-bit suffix input data 00 previously loaded in the D flip-flops 601 and 602 (the INPUT DATA section, 2, "SUFFIX INPUT DATA 1" in Table 4) are transferred to the D flip-flops 603 and 604, and new 2-bit suffix input data 00 (the INPUT DATA section, 3, "SUFFIX INPUT DATA 2" in Table 4) are loaded in the D flip-flops 601 and 602.

Encoded data (It is to be noted the data are entirely 001.) of the suffix input data 1 (00) loaded in the D flip-flops 603 and 604 are loaded to the D flip-flops 606 through 608 and outputted (the OUTPUT DATA section, 2, "ENCODED DATA OF SUFFIX INPUT DATA 1" in Table 4). These data are referred to as the suffix encoded data 408.

Next, the steps 701 through 703 are executed once again and encoded data are accordingly generated. The 2-bit suffix input data 00 previously loaded in the D flip-flops 601 and 602 (the INPUT DATA section, 3, "SUFFIX INPUT DATA 2" in Table 4) are transferred to the D flip-flops 603 and 604, and new 2-bit suffix input data 00 (not shown in Table 4) are loaded in the D flip-flops 601 and 602.

Encoded data (which are entirely 001.) of the suffix input data 2 (00) loaded in the D flip-flops 603 and 604 are loaded to the D flip-flops 606 through 608 and outputted (the OUTPUT DATA section, 3, "ENCODED DATA OF SUFFIX INPUT DATA 2" in Table 4).

This will be then repeated. The suffix encoded data 408 are the generic name of these data (repetition of 001).

In the embodiment 1, after encoded data of one ECC block are recorded to the end in the last segment of one ECC block, the suffix encoded data 408 described above are recorded at least two bits (00). When there is some room with respect to the channel bit count of the last segment of one ECC block, the suffix encoded data (001) are repeatedly recorded.

The data at the fourth and the following bits are dummy data.

Still, since the suffix encoded data 408 are always repetition of 001, even if the 3-bit suffix encoded data (001) described above do not exist, it is possible to encode all of the encoded data (See an embodiment 2.).

Table 6 shows decoding of the encoded data of Table 4. Table 6 will be described in detail in relation to the (1-7) encoder.

<DESCRIPTION OF REPRODUCING APPARATUS FOR OPTICAL DISK (FIG. 3)>

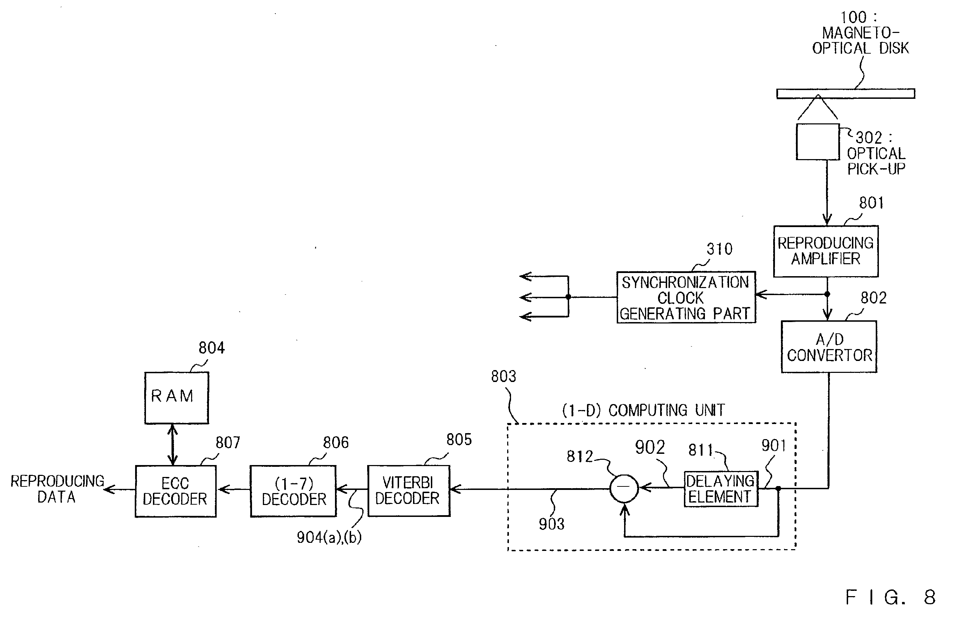

Fig. 8 shows a structure of a reproducing apparatus for the optical disk according to the embodiment 1.

In the drawing, denoted at 801 is a reproducing amplifier, denoted at 802 is a 10-bit A/D convertor (analog/ digital convertor), denoted at 803 is a (1-D) computing unit, denoted at 804 is a RAM, denoted at 805 is a viterbi decoder, denoted at 806 is a decoder using the (1-7) encoding scheme, and denoted at 807 is an ECC decoder.

Reflected light of laser light converged from the optical pick-up 302 is separated by a splitter (not shown) into light components which are in two deflection surfaces. Thus separated two light components are converted by two optical detectors (not shown) into two electric signals. The two electric signals are fed to a subtractor (not shown). The subtractor outputs a differential signal which represents a difference between the two electric signals.

After amplified by the reproducing amplifier 801, the differential signal is fed to the 10-bit A/D convertor 802 and converted into a 10-bit digital reproduction signal. The A/D convertor 802 sample-holds an input signal for every clock and digitizes the same, and outputs a digital reproduction signal.

The 10-bit digital reproduction signal (10-bit encoded data which are NRZI-converted) is fed to the (1-D) computing unit 803, and is converted into a differential signal (10-bit digital reproduction signal) of two consecutive reproduction signals.

Said differential signal of two consecutive reproduction signals is fed to the viterbi decoder 805 and subjected to maximum likelihood decoding, binarized (converted into 1-bit encoded data), and decoded by the NRZI scheme.

The viterbi decoder 805 outputs corrected encoded data (binary data) and transmits the same to the (1-7) decoder 806.

The (1-7) decoder 806 receives the corrected encoded data (binary data) and decodes by the (1-7) encoding scheme.

The data decoded by the (1-7) encoding scheme are fed to the ECC decoder 807 and written in the RAM 804. Following this, the data written in the RAM 804 are decoded by the ECC decoder 807 and error-corrected. The decoded data are read out from the RAM 804. Unnecessary data (suffix data, etc.) are removed when the decoded data are written in the RAM 804, and the respective data blocks (the data blocks of the respective segments) are connected into a continuous data stream when the ECC-decoded data are read out from the RAM 804.

The synchronization clock generating part 310 receives the reproduction signals outputted from the reproducing amplifier 801, and generates a reproduction clock.

<DESCRIPTION OF DECODING OF ENCODED DATA (FIG. 16)>

With reference to Fig. 16, a method of decoding encoded data will now be described. Part (a) of Fig. 16 shows portions of the first recording track 103 and the second recording track 104. The reproducing amplifier 801 outputs data blocks (which are shown in part (b) of Fig. 16) reproduced from the respective data recording areas 111 such as the first recording track 103. The top data block in an ECC block contains the constant data 406, the prefix encoded data 407 and the first data block 402. The second through the second last data blocks of the ECC block each contain the data 405 (predetermined data), which are the same as the last piece of encoded data of the immediately precedent data block, and the data block 403. The last data block in the ECC block contains the data 405 (predetermined data), which are the same as the last piece of encoded data of the immediately precedent data block, the last data block 404 and the suffix encoded data 408.

The (1-D) computing unit 803 and the viterbi decoder 805 binarize the output signals outputted (part (b) of Fig. 16) from the reproducing amplifier. As described in detail in relation to the (1-7) encoder, although the first one bit (predetermined data 405) in each data block plays an important role in removal of an influence exerted by a skew distortion and correct binarization of the reproduction signals, the predetermined data 405 themselves are not binarized. As shown in part (c) of Fig. 16, in an output signal (binary data) from the viterbi decoder 805, the top data block of the ECC block comprises the prefix encoded data 407 and the first data block 402. The second through the second last data blocks of the ECC block each contain the data block 403 (excluding the predetermined data 405). The last data block of the ECC block comprises the last data block 404 and the suffix encoded data 408 (excluding the predetermined data 405).

The (1-7) decoder 806 removes the predetermined data recorded before the top through the second through the last data blocks of the ECC block (the data 405 which are the same as the last piece of encoded data of the immediately precedent data block), and decodes the binary signal by a run length limit encoding scheme. As described later, when the encoded data at the top of each data block are to be decoded, decoding is performed using the last piece of encoded data of the immediately precedent data block, whereas when the encoded data at the end of each data block are to be decoded, decoding is performed using the encoded data at the top of the next data block. Hence, the (1-7) decoder 806 practically combines the binary signals representing a plurality of said data blocks to each other in the order of reproduction from the data recording areas, and decodes the combined binary signal as a whole as one data stream by a run length limit encoding scheme (part (d) of Fig. 16). The (1-7) decoder 806 practically outputs one decoded data stream as shown in part (e) of Fig. 16.

The ECC decoder 807 further decodes the data stream shown in part (e) of Fig. 16 and outputs.

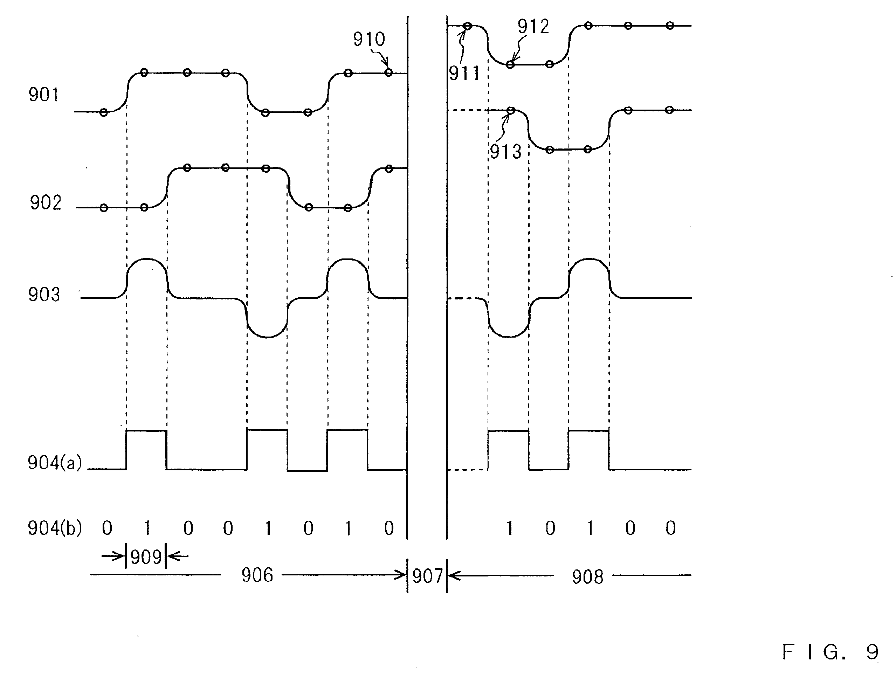

<DESCRIPTION OF (1-D) COMPUTING UNIT (FIG. 8, FIG. 9)>

The (1-D) computing unit 803 comprises a delaying element 811 and a subtractor 812 (Fig. 8).

Fig. 9 is a timing chart shows waveforms of the respective portions of the (1-D) computing unit 803.

In Fig. 9, denoted at 901 is the waveform of an input signal to the (1-D) computing unit 803 (the 10-bit digital reproduction signal outputted from the A/D convertor 802), denoted at 902 is the waveform of an output signal from the delaying element 811, denoted at 903 is the waveform of an output signal from the subtractor 812, and denoted at 904(a) is the waveform of an output signal (a signal which is binarized) from the viterbi decoder 805. Denoted at 904 (b) is a digital value of the output signal from the viterbi decoder 805.

Although denoted at 901 through 904 are all 10-bit digital signals, the signals are shown as analog signals for the convenience of illustration.

Further, Fig. 9 shows a waveform in a portion where two segment switch with each other.

Denoted at 906 is a reproducing period for the data recording area 111 of a precedent segment, denoted at 907 is a period of the pre-pit area 106, and denoted at 908 is a reproducing period for the data recording area 111 of a subsequent segment. Denoted at 909 is a period of one clock (one piece of data).

Fig. 9 omits the pre-write portion 116 and the post-write portion 117, and shows the period of the pre-pit area 106 narrower than it actually is.

The 10-bit digital reproduction signal 901 outputted from the A/D convertor 802 is fed to the delaying element 811 and the subtractor 812.

The delaying element 811 delays the 10-bit digital reproduction signal 901 by one clock, and outputs a delayed 10-bit digital reproduction signal 902.

The subtractor 812 subtracts the delayed 10-bit digital reproduction signal 902 from the 10-bit digital reproduction signal 901, and outputs a differential signal 903 representing the subtraction result ((differential signal 903) = (reproduction signal 901) - (reproduction signal 902)).

The reproduction signal has a large skew in portions where the optical pick-up moves to the ditch portion 111 from the pre-pit area 106 (sections denoted at 119 in part (c) of Fig. 1, 908 within 901 and 902 in Fig. 9). Since a skew component is a component whose frequency is far lower than a frequency of encoded data, skew components (DC transitions) of two reproduction signals which are apart in time by one clock are equal.

The subtractor 812 performs subtraction of the two signals 901 and 902, thereby canceling the skew components. Hence, the differential signal 903 not influenced by the skew components is generated.

Meanwhile, a differential signal on encoded data 911 added to the top is not generated. This removes the encoded data added to the top out from the reproduction signals.

A differential signal is generated from the second encoded data (data at the top of the data block) 912. For instance, the differential signal on the second encoded data 912 is expressed by the formula below:

$$\text{differential signal 903 = second encoded}$$

$$\text{data 912 - first encoded data 911}$$

Thus generated differential signal can be viewed as the output signal from the (1-7) decoder as it is made into 10-bit data and is added to with a noise.

From the data encoded by the (1-7) encoding scheme to which a noise was added (10-bit digital data), the viterbi decoder 805 selects binary encoded data which is at the shortest encoding distance using a viterbi algorithm, and outputs.

In this manner, the (1-D) computing unit 803 excludes an influence exerted by skew components and generates differential signals regarding the reproduction signals.

The differential signals are S(1) - S(0), S(2) - S(1), S(3) - S(2), ... S(n) - S(n-1), where the digital reproduction signals outputted from the A/D convertor are 10-bit digital data S(0), S(1), S(2), ... S(n).

Since the reproduction signal of the last encoded data of a precedent data block is S'(n) assuming that the digital reproduction signals of the precedent data block are 10-bit digital data S'(0), S'(1), S'(2), ... S'(n), S(1) - S(0) = S(1) - S'(n) from S'(n) = S(0) (The influence exerted by skew components and the like is removed.).

Hence, the differential signals generated from the reproduction signals of two data blocks are S'(1) - S'(0), S'(2) - S'(1), S'(3) - S'(2), ... S'(n) - S'(n-1), S(1) - S'(n), S(2) - S(1), S(3) - S(2), ... S(n) - S(n-1), thus showing continuity between adjacent data blocks.

In the (1-D) computing unit 803, it is important to accurately obtain the differential signals.

In the magneto-optical disk according to the embodiment 1, data (the added data 911 shown in Fig. 9) having the same value as the last encoded data 910 of a precedent segment (Fig. 9) are recorded at the top of the data recording area of each segment, and therefore, it is possible to accurately obtain the differential signals without influenced by skews.

In 901 shown in Fig. 9, but for the added 1-bit data 911, the subtractors 812 and 913 can not detect a change from the data 911 to 912.

As denoted at 901 and 902 in part (c) of Fig. 1 and Fig. 9, owing to an influence by a DC component in the pre-pit area 106, an influence of birefringence in the medium, etc., large fluctuations (skews), as they are taken as DC, are created between the data recording areas before and after the pre-pit area in reproduction waveforms. Hence, it is extremely difficult to obtain the accurate differential signal 903 between the data 912 which is at the top of the section 908 and the last data 910 in the section 906 = the reproduction signal 912 - the reproduction signal 910.

While a method used requires to binarize reproduction signals themselves and then generate a differential signal between two consecutive reproduction signals (detect a change from the data 910 to 912) instead of using a method which requires to note only a point of change and detect a differential signal because of this, since this method, too, is influenced by skews of the reproduction signals, it is difficult to accurately reproduce encoded data which were recorded.

Since a ditch portion or an inter-ditch portion immediately after the pre-pit area 106 is an area where a skew easily occurs in a reproduction signal, the area has been considered inappropriate as a data recording area. According to the embodiment 1, as data containing 1-bit data added to this area are recorded, it was possible to accurately and stably reproduce data utilizing this 1-bit data.

<DESCRIPTION OF VITERBI DECODER>

The viterbi decoder 805 receives two differential signals 903, performs maximum likelihood decoding, decodes through NRZI conversion, and outputs binarized encoded data 904(a), (b).

Thus outputted binary encoded data 904(a), (b) are data which were decoded through NRZI conversion.

The encoded data 904(a), (b), if including no error, are the same signals as the input signal to the NRZI convertor 311 (Fig. 3) as it is during recording.

The viterbi decoder 805 receives a differential signal (10-bit digital reproduction signal) between two consecutive reproduction signals outputted from the (1-D) computing unit 803, and performs maximum likelihood decoding.

Assume that output signals from the 10-bit A/D convertor 802 are S(0), S(1), S(2), ... S(n) in this order. It is assumed that S(0) is a reproduction signal having the same value as the last data of the precedent added data block, and S(1), S(2), ... S(n) are 10-bit digital signals.

The (1-D) computing unit 803 receives S(0), S(1), ... S(n) described above, and outputs S(1) - S(0), S(2) - S(1), S(3) - S(2), ... S(n) - S(n-1).

Expected values of these output signals are three values of A, 0 or -A (where A is a 10-bit digital signal). A, 0 and -A correspond respectively to differential signals on binary data 1, 0 and -1.

The viterbi decoder 805 applies output signals containing noise components from the (1-D) computing unit 803 to A (upward arrow), 0 (horizontal arrow) and -A (downward arrow), thereby determining transition states at all bits. Calculating a path matrix which represents the likelihood in each path transition and sequentially determining the most probable (most likely) path, the viterbi decoder 805 establishes transition states at the respective points (St1, St0).

The viterbi decoder 805 binarizes thus established states, and outputs binarized encoded data 904(a), (b)

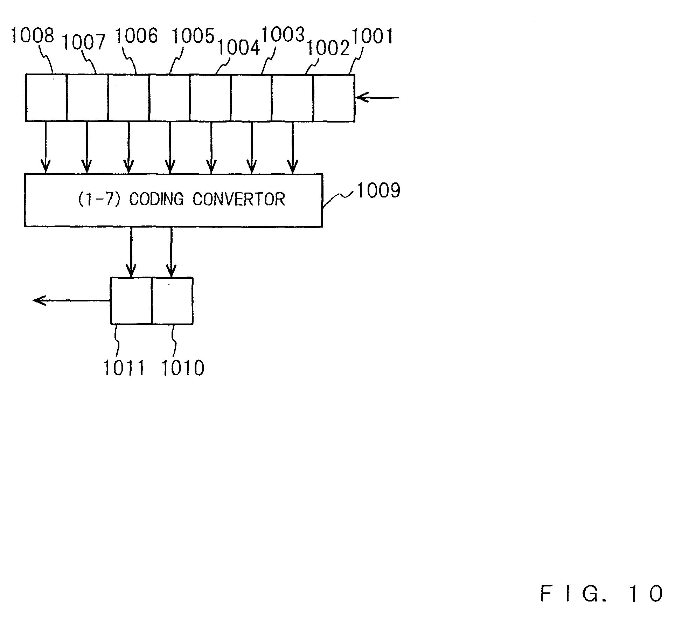

<DESCRIPTION OF STRUCTURE OF (1-7) DECODER (FIG. 10)>

The (1-7) decoder 806 using the (1-7) encoding scheme will now be described in more details.

Fig. 10 shows a structure of the (1-7) decoder 806 (Fig. 8) which uses the (1-7) encoding scheme.

D flip-flops (D-FF) 1001 through 1008 are serial input parallel output shift registers over eight stages, and shift input data from the (1-7) decoder 806 received at a D-input terminal of the D flip-flop 1001 and individually output in parallel.

A (1-7) coding convertor 1009 receives output signals from the D flip-flops 1002 and 1003 (the top two bits of encoded data which are the next decoding target), output signals from the D flip-flops 1004 through 1006 (encoded data which are a decoding target) and output signals from the D flip-flops 1007 and 1008 (the last two bits of encoded data which were a decoding target immediately before), and outputs 2-bit encoded data in accordance with the conversion rule shown in Table 2.

A structure of the (1-7) coding convertor 1009 may be any desired structure.

D flip-flops 1010 and 1011 are parallel input serial output shift registers over two stages, shift decoded data received at D-input terminals of the D flip-flops 1010 and 1011 (the output signals from the (1-7) decoding convertor 1009), and output at output terminal of the D flip-flop 1011.

The encoded data outputted from the D flip-flop 1011 are an output signal from the (1-7) decoder 806.

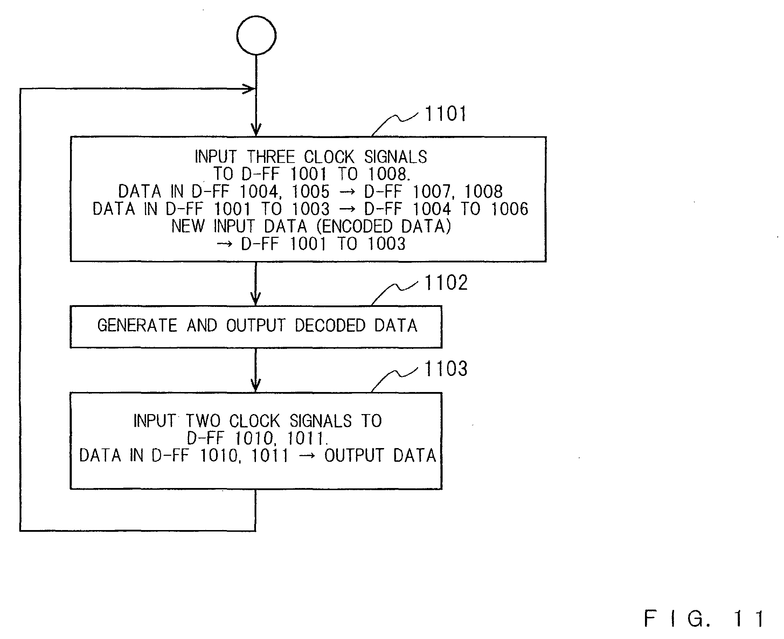

<DESCRIPTION OF OPERATIONS OF (1-7) DECODER (FIG. 11)>

Fig. 11 is a flow chart which shows operations of the (1-7) decoder 806 which uses the (1-7) encoding scheme.

First, three clock signals are fed to D flip-flops 1101 through 1008, signals already in the D flip-flops 1004 and 1005 are transferred to the D flip-flops 1007 and 1008, signals already in the D flip-flops 1001 through 1003 are transferred to the D flip-flops 1004 through 1006, and new 3-bit input data (encoded data) are loaded in the D flip-flops 1001 and 1003 (Step 1101).

Next, the (1-7) coding convertor 1009 receives the output signals from the D flip-flops 1002 through 1008, generates and outputs 2-bit decoded data in accordance with the conversion rule shown in Table 2 (Step 1102).

Next, at a step 1103, output signals from the (1-7) coding convertor 1009 are loaded in the D flip-flops 1010 and 1011, these D flip-flops receive two clock signals and shift thus loaded data. The two pieces of encoded data in the D flip-flops 1010 and 1011 are serially outputted.

The steps 1101 through 1103 described above will be then repeated.

When encoded data in the last three bits in the data block recorded in each segment are to be decoded, the last two bits of encoded data which were decoded immediately before are loaded in the D flip-flops 1007 and 1008, the last 3-bit data are loaded in the D flip-flops 1004 through 1006, encoded data at the top three bits of the next segment (The 1-bit data added to the top is removed.) loaded in the D flip-flops 1001 through 1003, and decoding is performed. In short, using data of data blocks in two adjacent segments, decoding is performed by the (1-7) encoding scheme.

Hence, as for the decoding described above, the decoding is executed upon loading of encoded data at the top three bits of the next segment. In a section of the pre-pit area disposed between two data recording areas, the (1-7) decoder 806 stops operating.

When encoded data in the top three bits in the data block recorded in each segment are to be decoded, the (1-7) decoder 806 which stopped operating in the section of the pre-pit area may be resumed.

The last two bits of the last encoded data of the data block recorded in a precedent segment are transferred from the D flip-flops 1004 and 1005 to the D flip-flops 1007 and 1008, the top 3-bit encoded data are transferred from the D flip-flops 1001 through 1003 into the D flip-flops 1004 through 1006, subsequent 3-bit encoded data are loaded into the D flip-flops 1001 through 1003 (The encoded data loaded in the D flip-flop 1001 are not used for decoding.),

and decoding is performed.

As described above, control of the clock signals makes it possible to easily execute decoding 3-bit encoded data at the end of the data block to be recorded in each segment and 3-bit encoded data at the top of the data block to be recorded in the next segment.

Decoding of encoded data at the top of one ECC block will now be described with reference to Table 5.

According to the (1-7) encoding scheme, using encoded data which are a decoding target and precedent and subsequent encoded data, it is possible to correctly decode encoded data.

In the embodiment 1, with prefix 3-bit encoded data generated and recorded, it is possible to correctly encode and decode a top data of data of one ECC block.

Table 5 shows decoding of a top data of data of one ECC block. Table 5 shows particular data as they are decoded in accordance with Table 2.

As described earlier, 3-bit prefix encoded data are recorded in front of encoded data of one ECC block (Con-

Table 5

TABLE OF DECODED DATA OF TOP ENCODED DATA

| NO. | INPUT DATA | | | | | OUTPUT DATA | | |
|---|---|---|---|---|---|---|---|---|
| | 0 | 1 | 2 | 3 | 4 | 1 | 2 | 3 |
| | LAST TWO BITS OF IMMEDIATELY PRECEDENT IMAGINARY ENCODED DATA | IMAGINARY ENCODED DATA TO BE DECODED | PREFIX ENCODED DATA TO BE DECODED | TOP ENCODED DATA TO BE DECODED | SUBSEQUENT ENCODED DATA | DECODED DATA OF IMAGINARY ENCODED DATA | DECODED DATA OF PREFIX ENCODED DATA | DECODED DATA OF TOP ENCODED DATA |
| 1 | 01 | 001 | 001 | 001 | 0X | 00 | 00 | 00 |
| 2 | 01 | 001 | 001 | 010 | 01 OR 10 | 00 | 00 | 00 |
| 3 | 01 | 001 | 001 | 010 | 00 | 00 | 00 | 01 |
| 4 | 01 | 001 | 001 | 000 | NOT 11 | 00 | 00 | 01 |
| 5 | 01 | 001 | 010 | 101 | 0X | 00 | 00 | 10 |
| 6 | 01 | 001 | 010 | 010 | 01 OR 10 | 00 | 00 | 10 |
| 7 | 01 | 001 | 010 | 010 | 00 | 00 | 00 | 11 |
| 8 | 01 | 001 | 010 | 100 | NOT 11 | 00 | 00 | 11 |

(X DENOTES 0 OR 1)

34

stant 1-bit data 0 added to the top have been already removed.). Using the prefix encoded data, it is possible to correctly decode the top encoded data.

After decoding of the encoded data of one ECC block is started, first, the steps 1101 through 1103 are executed twice in a row. This loads the 3-bit prefix encoded data (the INPUT DATA section, 2, "PREFIX ENCODED DATA TO BE DECODED" in Table 5) into the D flip-flops 1004 through 1006, and loads the 3-bit encoded data at the top (the INPUT DATA section, 3, "TOP ENCODED DATA TO BE DECODED" in Table 5) into the D flip-flops 1001 through 1003.

Next, the steps 1101 through 1103 are executed for the third time.

The last two bits of the prefix encoded data loaded in the D flip-flops 1005 and 1006 are transferred to the D flip-flops 1007 and 1008, the top 3-bit encoded data are loaded into the D flip-flops 1004 through 1006, and subsequent 3-bit encoded data (the INPUT DATA section, 4, "SUBSEQUENT ENCODED DATA" in Table 5) are newly loaded into the D flip-flops 1001 through 1003.

The (1-7) coding convertor 1009 decodes the encoded data loaded in the D flip-flops 1002 through 1008. Thus decoded data are loaded into the D flip-flops 1010 and 1011 and outputted (the OUTPUT DATA section, 3, "DECODED DATA OF TOP ENCODED DATA" in Table 5).

Decoding of the last encoded data of the encoded data of one ECC block will now be described with reference to Table 6.

In the magneto-optical disk according to the embodiment 1, constant encoded data (which are 001 in the embodiment 1) are added and recorded after the last encoded data of the encoded data of one ECC block. Using thus added constant encoded data, it is possible to decode the last encoded data of the encoded data of the one ECC block.

Table 6 shows decoding of the last encoded data of encoded data of one ECC block. Table 5 shows particular data as they are decoded in accordance with Table 2.

Table 6

TABLE OF DECODED DATA OF LAST ENCODED DATA

| NO. | INPUT DATA | | | | OUTPUT DATA | | |
|---|---|---|---|---|---|---|---|
| | 0<br>LAST TWO BITS OF IMMEDIATELY PRECEDENT ENCODED DATA | 1<br>LAST ENCODED DATA TO BE DECODED | 2<br>SUFFIX ENCODED DATA 1 | 3<br>SUFFIX ENCODED DATA 2 | 1<br>DECODED DATA OF LAST ENCODED DATA | 2<br>DECODED DATA OF SUFFIX ENCODED DATA 1 | 3<br>DECODED DATA OF SUFFIX ENCODED DATA 2 |
| 1 | 01 OR 10 | 001 | 001 | 001 | 00 | 00 | 00 |
| 2 | 00 | 001 | 001 | 001 | 01 | 00 | 00 |
| 3 | 01 | 010 | 001 | 001 | 01 | 00 | 00 |
| 4 | X0 | 101 | 001 | 001 | 10 | 00 | 00 |
| 5 | X0 | 010 | 001 | 001 | 11 | 00 | 00 |

(X DENOTES 0 OR 1)

The steps 1101 through 1103 are executed.

The last two bits of the second last piece of the encoded data loaded in the D flip-flops 1005 and 1006 (the INPUT DATA section, 0, "LAST TWO BITS OF IMMEDIATELY PRECEDENT ENCODED DATA" in Table 6) are transferred to the D flip-flops 1007 and 1008, the 3-bit last piece of the encoded data (the INPUT DATA section, 1, "LAST ENCODED DATA TO BE ENCODED" in Table 6) are transferred to the D flip-flops 1004 through 1006 from the D flip-flops 1001 through 1003, and subsequent 3-bit suffix encoded data (the INPUT DATA section, 2, "SUFFIX ENCODED DATA 1" in Table 6) are newly loaded into the D flip-flops 1001 through 1003.

The (1-7) coding convertor 1009 decodes the encoded data loaded in D flip-flops 1002 through 1008. Thus decoded data (data obtained by decoding the last piece of the encoded data) are loaded into the D flip-flops 1010 and 1011 and outputted (the OUTPUT DATA section, 1, "DECODED DATA OF LAST ENCODED DATA" in Table 6).

This may be or may not be followed by decoding of subsequent suffix encoded data 1, etc. In the event that decoding is performed, data obtained by decoding the subsequent suffix encoded data 1 or the like are 00 (the OUTPUT DATA section, 2, "DECODED DATA OF SUFFIX ENCODED DATA 1" or the like in Table 6). In this embodiment, decoding of the suffix encoded data is not executed.

Since the two bits at the top of the 3-bit suffix encoded data I are used in order to decode the last piece of the encoded data, the two bits at the top of the suffix encoded data 1 at least are recorded in the magneto-optical disk.

As described above, the recording apparatus according to the embodiment 1 divides continuous encoded data into a plurality of data recording areas and records the same in the magneto-optical disk, and adds data having the same value as the last piece of encoded data recorded in the precedent data recording area to the top of the next data recording area and records the same.

The reproducing apparatus according to the embodiment 1, by means of a simple structure, encodes by the (1-7) encoding scheme and decodes encoded data which are divided and recorded in different segments.

In the magneto-optical disk according to the embodiment 1, a small volume of additional information are added to encoded data of one ECC block divided into a plurality of segments (encoded by the (1-7) encoding scheme), accordingly made into such a condition which allows easy decoding, and recorded.

Further, it is possible to freely determine a channel bit count of each segment in 2-bit units which are smaller units than units of bytes, and hence, realize a high density magneto-optical disk which has a high format efficiency.

The recent years have seen an increasing interest in a magneto-optical disk of a magnetic wall movement detection type which makes it possible to record data whose mark length (a length of one bit of data on a data recording area in a recording medium) is equal to or shorter than a spot diameter of a light beam (See Japanese Patent Application Laid-Open No. 6-290496.).

In a magneto-optical recording medium of a magnetic wall movement detection type, a recording film is comprised of three layers of a recording layer, an intermediate layer and a reproduction layer. When a light beam is irradiated during reproduction, a temperature gradient is created in a portion of the recording film which is to be reproduced. In the recording film of this magneto-optical recording medium, when a constant temperature gradient is created, a magnetic wall of the reproduction layer within a recorded magnetic domain (which is a boundary surface between a magnetic domain which constitutes 1-bit recording data and an adjacent magnetic domain) moves and the length of the magnetic domain to be reproduced increases because of the movement of the magnetic wall. Since the length of the magnetic domain which used to be equal to or shorter than a spot diameter of the light beam is extended and accordingly becomes about the same as the spot diameter of the light beam, it is possible to detect a reproduction signal for this expanded magnetic domain with the optical pick-up.

In this manner, a reproducing resolution which is equal to or smaller than the spot diameter of the light beam is realized.

Since a magneto-optical recording medium of a magnetic wall movement detection type has a characteristic that a DC distortion (skew) is easily developed in a pre-pit area, the present invention which permits removal of a skew influence is particularly effective to a magneto-optical recording medium of a magnetic wall movement detection type and a recording apparatus and a reproducing apparatus for the same.

In addition, since a frequency of a reproduction signal for a magneto-optical recording medium of a magnetic wall movement detection type which realizes recording at a high density becomes very high, when encoded data encoded by the NRZI scheme are recorded, the present invention, which makes it possible to reduce a basic frequency of the reproduction signals, is particularly suitable to a magneto-optical recording medium of a magnetic wall movement detection type, etc.

<<EMBODIMENT 2>>

In the magneto-optical disk according to the embodiment 1, the predetermined data 406 (which are 0 in the embodiment 1) having one bit (a bit count of effective data) and 3-bit prefix encoded data (001 or 010) are recorded at the top of encoded data of one ECC block.

In a magneto-optical disk according to an embodiment 2, the predetermined data 406 (which may be 0 for example) having one bit (a bit count of effective data) and the last two bits of 3-bit prefix encoded data (01 or 10) are recorded at the top of encoded data of one ECC block.

This is because only the last two bits of 3-bit prefix encoded data (01 or 10) are needed for decoding of a top encoded data of encoded data of one ECC block.

The magneto-optical disk according to the embodiment 2 is otherwise the same as the magneto-optical disk according to the embodiment 1.

<<EMBODIMENT 3>>

In the last segment of one ECC block on the magneto-optical disk according to the embodiment 1, the suffix encoded data 408 are recorded even after recording of the last piece of encoded data.

In the last segment of one ECC block on a magneto-optical disk according to an embodiment 3, nothing is recorded after recording of the last piece of encoded data.

In a reproducing apparatus for the magneto-optical disk according to the embodiment 3, at the time of decoding of the last piece of encoded data, the following processing which is different from ordinary processing is executed.

In Fig. 10, for decoding of the last piece of encoded data, the last two of encoded data which were decoded immediately before are transferred to the D flip-flops 1007 and 1008 from the D flip-flops 1004 and 1005, the 3-bit last piece of the encoded data are transferred to the D flip-flops 1004 through 1006 from the D flip-flops 1001 through 1003, and a constant value 001 (the value in the INPUT DATA section, 2, "SUFFIX ENCODED DATA 1" in Table 6; recorded by the (1-7) decoder 806) is loaded in the D flip-flops 1001 through 1003.

The (1-7) coding convertor 1009 receives the encoded data outputted from the D flip-flops 1002 through 1008, decodes, and outputs decoded data. The decoded data are loaded in the D flip-flops 1010 and 1011, shifted and outputted.

A clock counter (not shown) built within the (1-7) decoder 806 detects the last piece of the encoded data.

The clock counter may count the number of encoded data inputted to the (1-7) decoder 806, the number of decoding processes performed by the (1-7) decoder 806, or the number of decoded data outputted from the (1-7) decoder 806, for instance.

As the value in the INPUT DATA section, 2, "SUFFIX ENCODED DATA 1" in Table 6 shows, since the suffix encoded data 408 are always succession of 001 in this embodiment, it is possible to realize the magneto-optical disk according to the embodiment 3 and the reproducing apparatus for the same.

Since the data loaded in the D flip-flop 1001 are not used, 000 may be loaded in the D flip-flops 1001 through 1003 instead of the constant value 001.

With respect to this point, the magneto-optical disk according to the embodiment 3 and the reproducing apparatus for the same are the same as the magneto-optical disk according to the embodiment 1 and the reproducing apparatus for the same.

<<EMBODIMENT 4>>

A recording method for a recording medium according to an embodiment 4 will now be described.

Fig. 13 shows the recording method for the recording medium according to the embodiment 4.

First, input data are encoded, ECC encoding is executed, and an ECC block is generated (Step 1301).

Next, a plurality of data blocks are generated which are obtained by dividing one data stream (ECC block) (Step 1302).

Next, prefix data are added before the top data block, and suffix data are added after the last data block (Step 1303).

Next, each data block is encoded by the (1-7) encoding scheme and the NRZI scheme (Step 1304). When the top data in each data block are to be encoded, encoding is executed using the last data of an immediately precedent data block, and when the last data in each data block are to be encoded, encoding is executed using the top data of the last data block.

Next, data having a constant value are added before the prefix encoded data and the top data block, thereby generating a data block which contains the added data (Step 1305).

A bit count of the data having the constant value may be any desired count. It is preferable that the data having the constant value are 5-bit data which contain 1-bit data which are effective data and 4-bit data which are to be recorded in the pre-write portion (The five bits are data of entirely equal values).

It is preferable that after the top data block, 4-bit data having the same value as the last 1-bit encoded data of the top data block are added. Thus added 4-bit data are recorded in the post-write portion of the recording medium at the next step 1306.

Next, the top data block containing the added data are recorded in the top segment of the recording medium (Step 1306). The 4-bit data described above are recorded in the pre-write portion and the post-write portion, respectively.

Next, data having the same value as the last 1-bit encoded data of the precedent data block are added before the second data block, thereby generating a data block which contains the added data (Step 1307).

A bit count of the data having the same value as the last 1-bit encoded data of the precedent data block may be any desired count. It is preferable that this data having the same value are 5-bit data which contain one bit which is effective data and 4-bit data which are to be recorded in the pre-write portion (The five bits are data of entirely equal values).

It is preferable that after the second data block, 4-bit data having the same value as the last 1-bit encoded data of the second data block are added. Thus added 4-bit data are recorded in the post-write portion of the recording medium at the next step 1308.

Next, the second data block containing the added data are recorded in the second segment of the recording medium (Step 1308). The 4-bit data described above are recorded in the pre-write portion and the post-write portion, respectively.

The step 1307 and the step 1308 will be then repeated, thereby generating a third data block which contains added data and recording thus generated data block in the third segment of the recording medium.

Next, data having the same value as the last 1-bit encoded data of the precedent data block are added before the last data block and suffix encoded data, thereby generating a data block which contains the added data (Step 1309).

A bit count of the data having the same value as the last 1-bit encoded data of the precedent data block may be any desired count. It is preferable that this data having the same value are 5-bit data which contain one bit which is effective data and 4-bit data which are to be recorded in the pre-write portion (The five bits are data of entirely equal values).

The suffix encoded data preferably fill up the data recording area of the recording medium and have a channel bit count which permits further 4-bit suffix encoded data to be recorded in the pre-write portion and the post-write portion. Thus added 4-bit data are recorded in the post-write portion of the recording medium at the subsequent step 1310.

Next, the last data block containing the added data are recorded in the last segment of the recording medium (Step 1310). The 4-bit data described above are recorded in the pre-write portion and the post-write portion, respectively.

The steps 1301 through 1310 will be then repeated.

<<EMBODIMENT 5>>

A reproduction method for a recording medium according to an embodiment 5 will now be described. The reproduction method according to the embodiment 5 is for reproducing data from a recording medium in which data were recorded by the recording method according to the embodiment 4 described above.

Fig. 14 shows the reproduction method for recording medium according to the embodiment 5.

First, a reproduction signal for one ECC block is reproduced from the recording medium (Step 1401). A signal for one ECC block is recorded as it is divided over a plurality of segments.

Next, the reproduction signal is converted into 10-bit digital data S(0), S(1), S(2), ... S(n) (Step 1402). The reproduction signals read out from the pre-write portions and the post-write portions are not converted, but are removed.

Next, differential signals S(1) - S(0), S(2) - S(1), S(3) - S(2), ... S(n) - S(n-1) between two consecutive reproduction signals are generated (Step 1403).

Assuming that the reproduction signal for the precedent data block is 10-bit digital data S(0), S(1), S(2), ... S(n), since the reproduction signal for the last encoded data of the precedent data block is S'(n), S(1) - S'(n) from S(1) = S(0) (The influence exerted by skew components and the like is removed.).

Hence, the differential signals for two consecutive segments are S'(1) - S'(0), S'(2) - S'(1), S'(3) - S'(2), ... S'(n) - S'(n-1), S(1) - S'(n), S(2) - S(1), S(3) - S(2), ... S(n) - S(n-1), thus showing continuity between adjacent data blocks.

Next, a path matrix which represents the likelihood is calculated from the differential signals and the most probable path is accordingly determined, and the differential signals are binarized (Step 1404). At this stage, NRZI conversion decoding has completed.

Next, the binary data are decoded by the (1-7) encoding scheme (Step 1405). It is possible to decode the last encoded data of one data block using this last encoded data, the second last encoded data and the top encoded data of the next data block.

In a similar fashion, it is possible to decode the top encoded data of the next data block using the last encoded data of the precedent data block, the top encoded data of the next data block and the second encoded data from the top of the next data block.

Using prefix encoded data and suffix encoded data, it is possible to decode the top encoded data of the top data block and the last encoded data of the last data block.

Next, the decoded data described above are decoded by an ECC encoding scheme (Step 1406).

Next, the decoded data are outputted as a continuous data stream (Step 1407).

The steps 1401 through 1407 will be then repeated.

<<EMBODIMENT 6>>

A reproduction method for a recording medium according to an embodiment 6 will now be described.

According to the recording method according to the embodiment 4 described earlier, suffix encoded data are recorded after the last data block in a recording method. According to a recording method according to other embodiment, nothing is recorded after the last data block.

The reproduction method according to the embodiment 6 is a reproduction method which requires to reproduce data from a recording medium in which nothing is recorded after the last data block.

Fig. 15 shows the reproduction method for recording medium according to the embodiment 6. The reproduction method for recording medium according to the embodiment 6 is the same flow chart which is basically the same as the reproduction method for recording medium according to the embodiment 5.

First, a reproduction signal for one ECC block is reproduced from the recording medium (Step 1501). A signal for one ECC block is recorded as it is divided over a plurality of segments.

Next, the reproduction signal is converted into 10-bit digital data S(0), S(1), S(2), ... S(n) (Step 1502). The reproduction signals read out from the pre-write portions and the post-write portions are not converted, but are removed.

Next, differential signals S(1) - S(0), S(2) - S(1), S(3) - S(2), ... S(n) - S(n-1) between two consecutive reproduction signals are generated (Step 1503).

The differential signals have continuity between adjacent data blocks.

Next, a path matrix which represents the likelihood is calculated from the differential signals and the most probable path is accordingly determined, and the differential signals are binarized (Step 1504). At this stage, NRZI conversion decoding has completed.

Next, a counter k representing the number of encoded data which have been already decoded is set to k = 0 (initialized) (Step 1505).

Next, the binary encoded data are decoded three bits each by the (1-7) encoding scheme (Step 1506).

Next, k = k + 3 is set (Step 1507).

Next, whether the value k is the same as the number klast of the last encoded data is checked (Step 1508).

When the value k is the same as the number klast of the last encoded data, the sequence proceeds to a step 1509.

When the value k is not the same as the number klast of the last encoded data, the sequence returns to the step 1506, and the steps 1506 through 1508 are repeated.

Using the second last encoded data, the last encoded data and the top encoded data of the next data block, it is possible to decode the last encoded data of one data block.

In a similar fashion, it is possible to decode the top encoded data of the next data block using the last encoded data of the precedent data block, the top encoded data of the next data block and the second encoded data from the top of the next data block.

Use of prefix encoded data makes it possible to decode the top encoded data of the top data block.

At the step 1509, the last encoded data of the last data block, the second last encoded data, the last encoded data and the constant value (which is 001 in this embodiment) are used together, and decoding is executed by the (1-7) encoding scheme.

Next, the decoded data described above are decoded by an ECC encoding scheme (Step 1510).

Next, the decoded data are outputted as a continuous data stream (Step 1511).

The steps 1501 through 1511 will be then repeated.

In the embodiments described above, an ECC block is divided into a plurality of data blocks first, and each data block is then encoded by the (1-7) encoding scheme and NRZI-converted. Yet, when the top data of each data block are to be encoded by the (1-7) encoding scheme, encoding is performed using the last data of an immediately precedent data block, and when the last data of each data block are to be encoded by the (1-7) encoding scheme, encoding is performed using the top data of the next data block.

However, the structure according to the present invention is not limited to this: After encoding of an ECC block as a whole by the (1-7) encoding scheme, generated encoded data are written in the RAM, the encoded data may be then divided into a plurality of data blocks and read out, and then NRZI-converted for each data block.

In a similar fashion, generated encoded data may be written in the RAM after encoding of an ECC block as a whole by the (1-7) encoding scheme and NRZI conversion, and the encoded data may be then divided into a plurality of data blocks and read out.

Any one of the structures described above is included in the technical scope of the encoding unit described in the attached claims.

Further, while the embodiments require to generate an ECC block first, this is not limiting: Other encoded signal may be used, or data which are not encoded may be used.

Although the (1-7) encoding scheme is used in the embodiments of the present invention, instead of this, the present invention can be implemented using other run length limit encoding scheme (which may be the (2-7) encoding scheme for instance) or any other desired run length limit encoding scheme which requires to use precedent or subsequent encoded data for execution of decoding.

In addition, the present invention is applicable to recording mediums of any one of the CAV (Constant Angular Velocity) type which requires to rotate a recording medium into constant revolutions for recording and reproduction, the CLV (Constant Linear Velocity) type which requires to rotate a recording medium in such a manner that a linear velocity will be constant for recording and reproduction and the ZCLV method (Zoned CLV) type and the like.

Further, the present invention is applicable not only to magneto-optical disks but also to any desired recording mediums such as phase-conversion optical disks, magnetic cards and the like.

The recording method or the reproduction method according to the embodiments described above can be executed, as a recording medium, in which software program is recorded for a recording or reproduction method for execution of all or some of the functions of the recording method or the reproduction method according to the embodiments described above, is mounted to a reader apparatus for recording medium (recording medium for a software program) disposed to a recording apparatus or reproducing apparatus for recording medium (recording medium for data) such as optical disks, and the software program is loaded in the recording apparatus or reproducing apparatus and executed.

The present invention achieves an advantageous effect that it is possible to realize a recording medium which has a high effective recording density and a recording apparatus and a reproducing apparatus for the same, owing to continuity between encoded data belonging to each data recording area and encoded data belonging to precedent and subsequent data recording areas.

In addition, it becomes possible to determine a channel bit count of a data recording area independently of a data volume of one ECC block, which in turn permits to realize a high density recording medium having a high format efficiency and a recording apparatus and a recording method for the same.

The present invention achieves an advantageous effect that particularly in a recording medium wherein one ECC block is divided into a number of data recording areas (e.g., a disk-shaped recording medium in which a recording track whose length is one round is divided into 1000 or more data recording areas), it is possible to realize a recording medium which has a high effective recording density and a high error correcting capability, and a recording apparatus and a recording method for the same.

The present invention achieves an advantageous effect that it is possible to realize a recording medium which permits a reproducing apparatus to accurately binarize a reproduction signal which contains a skew distortion (a low-frequency waveform distortion), and a recording apparatus and a recording method for the same.

Further, with a reproducing apparatus for a recording medium which holds encoded data which were encoded by the (1-7) encoding scheme and NRZI-converted for example, it is possible to decode encoded data with reference to predetermined data for each data recording area without influenced by a skew distortion.

The present invention achieves an advantageous effect that it is possible to realize a recording medium which can be more accurately reproduced with a reproducing apparatus which has a simple structure, and a recording apparatus and a recording method for the same.

The present invention achieves an advantageous effect that it is possible to realize a recording medium which permits to simplify structures of clock control circuits of a recording apparatus and a reproducing apparatus, and a recording apparatus for the same.

The present invention achieves an advantageous effect that it is possible to realize a reproducing apparatus and a reproduction method having simple structures which accurately reproduce a reproduction signal.

The present invention achieves an advantageous effect that it is possible to realize a reproducing apparatus and a reproduction method which make it possible to reproduce data from the recording medium according to the present invention.

The present invention achieves an advantageous effect that it is possible to realize a reproducing apparatus and a reproduction method which make it possible to decode a reproduction signal reproduced from a recording medium in which suffix data, which are for decoding of the last piece of encoded data, are not recorded.

An advantageous effect is obtained that when encoded data or the like of one ECC block are recorded in a plurality of segments, in the event that data which are as large as a channel bit count are recorded in the last segment and there is no more room for recording of suffix data, it is not necessary to add one new segment to this ECC block only for the purpose of recording suffix data.

While the foregoing has described preferred embodiments of the present invention in detail to a constant extent, the disclosure regarding the details on the structures according to the preferred embodiments shall be modified, and it is possible to change a combination and order of the respective elements without deviating from the scope of the claimed invention and the idea of the invention.

INDUSTRIAL APPLICABILITY

The recording medium, and the recording apparatus, the reproducing apparatus, the recording method and the reproduction method for the same according to the present invention are useful as a recording medium such as an optical disk for recording various types of digital data, such as a video signal, an audio signal and computer data for instance, and a recording apparatus, a reproducing apparatus, a recording method and a reproduction method for the same.

**Claims**

1. A recording medium, comprising:

   a pre-pit area comprising pre-pits; and
   a plurality of data recording areas which are divided by said pre-pit areas and in which a data block is recorded which is obtained by dividing one data stream which is formed by encoded data which are encoded by an encoding scheme including a run length limit encoding scheme,

   wherein in at least one data recording area, data having a predetermined value of at lease one bit are further recorded in front of said data block.

2. A recording medium, comprising:

   a pre-pit area comprising pre-pits; and
   a plurality of data recording areas which are divided by said pre-pit areas and in which a data block is recorded which is obtained by dividing one data stream which is formed by encoded data which are encoded by an encoding scheme including a run length limit encoding scheme,

   wherein in at least one data recording area, data having the same value as the last one bit of said encoded data in said data recording area which is before said data recording area are further recorded in front of said data block.

3. The recording medium of claim 1, wherein said data block has said encoded data in a data volume which is an integer multiple of 2 if a data volume is converted into a volume of data before being encoded by a run length limit encoding scheme.

4. A recording apparatus, comprising:

   an encoding unit which generates a plurality of data blocks which are obtained by dividing one data stream which is formed by encoded data which are obtained by encoding input data by an encoding scheme including a run length limit encoding scheme;
   a data adding unit which adds data having a predetermined value of at lease one bit to the top of at least one of divided said data blocks and generates a data block which contains thus added data; and
   a recording unit which records said data block which contains thus added data in said recording medium.

5. A recording apparatus, comprising:

   an encoding unit which generates a plurality of data blocks which are obtained by dividing one data stream which is formed by encoded data which are obtained by encoding input data by an encoding scheme including a run length limit encoding scheme;
   a data adding unit which adds data having the same value as the last one bit of said encoded data in said data block which is before at least one of divided said data blocks to the top of at least one of divided said data blocks and generates a data block which contains thus added data; and
   a recording unit which records said data block which contains thus added data in said recording medium.

6. The recording apparatus of claim 4, wherein said data block has said encoded data in a data volume which is an integer multiple of 2 if a data volume is converted into a volume of data before being encoded by a run length limit encoding scheme.

7. The recording apparatus of any one of claims 4 through 6, wherein said encoding unit or said data adding unit adds, after the last piece of said encoded data, data having a predetermined value of n bits (where n is any desired positive integer).

8. A reproducing apparatus, comprising:

a reproducing unit which reproduces signals recorded in a recording medium and outputs reproduction signals;
a difference detecting unit which generates differential signals which represent a difference between two consecutive ones of said reproduction signals;
a binary data generating unit which generates binary data which are binarized based on said differential signals; and
a decoding unit which decodes said binary data by a run length limit encoding scheme.

9. A reproducing apparatus, comprising:

a reproducing unit which reproduces, from a recording medium, encoded data which are encoded by an encoding scheme including a run length limit encoding scheme and recorded as they are divided into a plurality of data blocks; and
a decoding unit which, using said encoded data of said data block and said encoded data of the next data block, decodes said encoded data of said data block or the next data block.

10. A reproducing apparatus, comprising:

a reproducing unit which reproduces and outputs, from each one of a plurality of data recording areas of a recording medium, reproduction signals of data blocks and predetermined data further recorded before said data blocks;
a binarizing unit which binarizes said reproduction signals and outputs binary signals; and
a decoding unit which combines, in the order of reproduction from said data recording areas, said binary signals of a plurality of said data blocks with each other except for said predetermined data of other data blocks than at least the top data block, and decodes said binary signals thus combined by a run length limit encoding scheme.

11. A reproducing apparatus, comprising:

a reproducing unit which reproduces a data stream of encoded data which are encoded by an encoding scheme including a run length limit encoding scheme from a recording medium;
a counter which counts the number of encoded data of said data stream, the number of encoding processes or the number of decoded data;
a last encoded data detecting unit which detects a last encoded data of said data stream based on the value of said counter; and
a decoding unit which, when said last encoded data detecting unit detects that a decoding-target encoded data is said last encoded data, decodes said decoding-target encoded data using at least said decoding-target encoded data and data having a constant value.

12. A recording method, comprising:

an encoding step of generating a plurality of data blocks which are obtained by dividing one data stream which is formed by encoded data which are obtained by encoding input data by an encoding scheme including a run length limit encoding scheme;
a data adding step of adding data having a predetermined value of at lease one bit to the top of at least one of divided said data blocks and generating a data block which contains thus added data; and
a recording step of recording said data block which contains thus added data in said recording medium.

13. A recording method, comprising:

an encoding step of generating a plurality of data blocks which are obtained by dividing one data stream which is formed by encoded data which are obtained by encoding input data by an encoding scheme including a run length limit encoding scheme;

a data adding step of adding data having the same value as the last one bit of said encoded data in said data block which is before at least one of divided said data blocks to the top of at least one of divided said data blocks and generates a data block which contains thus added data; and

a recording step of recording said data block which contains thus added data in said recording medium.

14. The recording method of claim 12, wherein said data block has said encoded data in a data volume which is an integer multiple of 2 if a data volume is converted into a volume of data before being encoded by a run length limit encoding scheme.

15. The recording method of any one of claims 12 through 14, wherein at said encoding step or said data adding step, data having a predetermined value of n bits (where n is any desired positive integer) are added after the last piece of said encoded data.

16. A reproduction method, comprising:

a reproducing step of reproducing signals recorded in a recording medium and outputting reproduction signals;

a difference detecting step of generating differential signals which represent a difference between two consecutive ones of said reproduction signals;

a binary data generating step of generating binary data which are binarized based on said differential signals; and

a decoding step of decoding said binary data by a run length limit encoding scheme.

17. A reproduction method, comprising:

a reproducing step of reproducing, from a recording medium, encoded data which are encoded by an encoding scheme including a run length limit encoding scheme and recorded as they are divided into a plurality of data blocks; and

a decoding step of, using said encoded data of said data block and said encoded data of the next data block, decoding said encoded data of said data block or the next encoded data.

18. A reproduction method, comprising:

a reproducing step of reproducing and outputting, from each one of a plurality of data recording areas of a recording medium, reproduction signals of data blocks and predetermined data further recorded before said data blocks;

a binarizing step of binarizing said reproduction signals and outputting binary signals; and

a decoding step of combining, in the order of reproduction from said data recording areas, said binary signals of a plurality of said data blocks with each other except for said predetermined data of other data blocks than at least the top data block, and decoding said binary signals thus combined by a run length limit encoding scheme.

19. A reproduction method, comprising:

a reproducing step of reproducing, from a recording medium, a data stream of encoded data which are encoded by an encoding scheme including a run length limit encoding scheme;

a counting step of counting the number of encoded data of said data stream, the number of encoding processes or the number of decoded data;

a last encoded data detecting step of detecting a last encoded data of said data stream based on the value of said counter; and

a decoding step of, when said last encoded data detecting unit detects that a decoding-target encoded data is said last encoded data, decoding said decoding-target encoded data while using at least said decoding-target encoded data and data having a constant value.

**Amended claims under Art. 19.1 PCT**

1. (Amended) A disk-shaped information recording medium divided into a plurality of zones along the radius direction, comprising:

a pre-pit area comprising pre-pits; and

a plurality of data recording areas which are divided by said pre-pit area and in which a data block is recorded which is obtained by dividing one data stream which is formed by encoded data which are encoded by an encoding scheme including a run length limit encoding scheme,

wherein bit counts of said data recording areas are different between said zones, and

in at least one data recording area within each zone, data having a predetermined value of at lease one bit are further recorded in front of said data block.

**2.** (Amended) A disk-shaped information recording medium divided into a plurality of zones along the radius direction, comprising:

a pre-pit area comprising pre-pits; and

a plurality of data recording areas which are divided by said pre-pit area and in which a data block is recorded which is obtained by dividing one data stream which is formed by encoded data which are encoded by an encoding scheme including a run length limit encoding scheme,

wherein bit counts of said data recording areas are different between said zones, and

in at least one data recording area within each zone, data having the same value as the last one bit of said encoded data in said data recording area which is before said data recording area are further recorded in front of said data block.

**3.** The recording medium of claim 1, wherein said data block has said encoded data in a data volume which is an integer multiple of 2 if a data volume is converted into a volume of data before being encoded by a run length limit encoding scheme.

**4.** (Amended) A recording apparatus for a disk-shaped information recording medium in which a plurality of zones divided along the radius direction are disposed, said zones comprise a plurality of data recording areas and bit counts of said data recording areas are different between said zones, wherein said recording apparatus comprises:

an encoding unit which generates a plurality of data blocks which are obtained by dividing one data stream, which is formed by encoded data which are obtained by encoding input data by an encoding scheme including a run length limit encoding scheme, in accordance with the bit count of said data recording areas;

a data adding unit which adds data having a predetermined value of at lease one bit to the top of at least one of divided said data blocks, and generates a data block which contains thus added data; and

a recording unit which records said data block which contains thus added data in each one of said data recording areas.

**5.** (Amended) The recording apparatus of claim 4, wherein said data having said predetermined value are data having the same value as the last one bit of said encoded data in a precedent one of said data blocks.

**6.** The recording apparatus of claim 4, wherein said data block has said encoded data in a data volume which is an integer multiple of 2 if a data volume is converted into a volume of data before being encoded by a run length limit encoding scheme.

**7.** The recording apparatus of any one of claims 4 through 6, wherein said encoding unit or said data adding unit adds, after the last piece of said encoded data, data having a predetermined value of n bits (where n is any desired positive integer).

**8.** (Amended) A reproducing apparatus for a disk-shaped information recording medium in which a plurality of zones divided along the radius direction are disposed, said zones comprise a plurality of data recording areas and bit counts of said data recording areas are different between said zones, wherein said reproducing apparatus comprises:

a reproducing unit which reproduces signals recorded in said data recording areas and outputs reproduction signals;

a difference detecting unit which generates differential signals which represent a difference between two consecutive ones of said reproduction signals;

a binary data generating unit which generates binary data which are binarized except for the top one bits of said signals recorded in said data recording areas, based on said differential signals; and

a decoding unit which decodes and combines said binary data of a plurality of said data recording areas by a run length limit encoding scheme, and generates one data stream.

**9.** (Amended) A reproducing apparatus for a disk-shaped information recording medium comprising a plurality of zones divided along the radius direction,

in which said zones comprise a plurality of data recording areas, and

encoded data, which are generated by encoding by an encoding scheme including a run length limit encoding scheme and by dividing into a plurality of data blocks and which have different bit counts between said zones, are recorded in said data recording areas,

wherein said reproducing apparatus comprises:

a reproducing unit which reproduces encoded data of said data blocks from each one of a plurality of said data recording areas; and

a decoding unit which, using said encoded data of said data block and said encoded data of the next data block, decodes said encoded data of said data block or the next data block, combines decoded data from a plurality of said data blocks and outputs one data stream.

**10.** (Amended) A reproducing apparatus for a disk-shaped information recording medium comprising a plurality of zones divided along the radius direction,

in which said zones comprise a plurality of data recording areas, and

encoded data, which are generated by encoding by an encoding scheme including a run length limit encoding scheme, by dividing into a plurality of data blocks and by adding predetermined data before said data blocks, and which have different bit counts between said zones, are recorded in said data recording areas,

wherein said reproducing apparatus comprises:

a reproducing unit which reproduces and outputs, from each one of a plurality of said data recording areas, reproduction signals of said data blocks and said predetermined data further recorded in front of said data blocks;

a binarizing unit which binarizes said reproduction signals and outputs binary signals; and

a decoding unit which combines, in the order of reproduction from said data recording areas, said binary signals of a plurality of said data blocks with each other except for said predetermined data of other data blocks than at least the top data block, and decodes said binary signals thus combined by a run length limit encoding scheme.

**11.** A reproducing apparatus, comprising:

a reproducing unit which reproduces a data stream of encoded data which are encoded by an encoding scheme including a run length limit encoding scheme from a recording medium;

a counter which counts the number of encoded data of said data stream, the number of encoding processes or the number of decoded data;

a last encoded data detecting unit which detects a last encoded data of said data stream based on the value of said counter; and

a decoding unit which, when said last encoded data detecting unit detects that a decoding-target encoded data is said last encoded data, decodes said decoding-target encoded data using at least said decoding-target encoded data and data having a constant value.

**12.** (Amended) A recording method for a disk-shaped information recording medium in which a plurality of zones divided along the radius direction are disposed, said zones comprise a plurality of data recording areas and bit counts of said data recording areas are different between said zones, wherein said recording method comprises:

an encoding step of generating a plurality of data blocks which are obtained by dividing one data stream, which is formed by encoded data which are obtained by encoding input data by an encoding scheme including a run length limit encoding scheme, in accordance with the bit count of said data recording areas;

a data adding step of adding data having a predetermined value of at lease one bit to the top of at least one of divided said data blocks and generating a data block which contains thus added data; and

a recording step of recording said data block which contains thus added data in each one of said data recording areas.

**13.** (Amended) The recording method of claim 12, wherein said data having said predetermined value are data having the same value as the last one bit of said encoded data in a precedent one of said data blocks.

**14.** The recording method of claim 12, wherein said data block has said encoded data in a data volume which is an integer multiple of 2 if a data volume is converted into a volume of data before being encoded by a run length limit encoding scheme.

**15.** The recording method of any one of claims 12 through 14, wherein at said encoding step or said data adding step, data having a predetermined value of n bits (where n is any desired positive integer) are added after the last piece of said encoded data.

**16.** (Amended) A reproduction method for a disk-shaped information recording medium in which a plurality of zones divided along the radius direction are disposed, said zones comprise a plurality of data recording areas and bit counts of said data recording areas are different between said zones, wherein said recording method comprises:

a reproducing step of reproducing signals recorded in said data recording areas and outputting reproduction signals;
a difference detecting step of generating differential signals which represent a difference between two consecutive ones of said reproduction signals;
a binary data generating step of generating binary data which are binarized except for the top one bits of said signals recorded in said data recording areas, based on said differential signals; and
a decoding step of decoding and combining said binary data of a plurality of said data recording areas by a run length limit encoding scheme, and generating one data stream.

**17.** (Amended) A reproduction method for a disk-shaped information recording medium comprising a plurality of zones divided along the radius direction,
    in which said zones comprise a plurality of data recording areas, and
    encoded data, which are generated by encoding by an encoding scheme including a run length limit encoding scheme and by dividing into a plurality of data blocks and which have different bit counts between said zones, are recorded in said data recording areas,
    wherein said reproduction method comprises:

a reproducing step of reproducing encoded data of said data blocks from each one of a plurality of said data recording areas; and
a decoding step of, using said encoded data of said data block and said encoded data of the next data block, decoding said encoded data of said data block or the next data block, combining decoded data from a plurality of said data blocks and outputting one data stream.

**18.** (Amended) A reproduction method for a disk-shaped information recording medium comprising a plurality of zones divided along the radius direction,
    in which said zones comprise a plurality of data recording areas, and
    encoded data, which are generated by encoding by an encoding scheme including a run length limit encoding scheme, by dividing into a plurality of data blocks and by adding predetermined data before said data blocks and which have different bit counts between said zones, are recorded in said data recording areas,
    wherein said reproducing method comprises:

a reproducing step of reproducing and outputting, from each one of a plurality of said data recording areas, reproduction signals of said data blocks and said predetermined data further recorded in front of said data blocks;
a binarizing step of binarizing said reproduction signals and outputting binary signals; and
a decoding step of combining, in the order of reproduction from said data recording areas, said binary signals of a plurality of said data blocks with each other except for said predetermined data of other data blocks than at least the top data block, and decoding said binary signals thus combined by a run length limit encoding scheme.

**19.** A reproduction method, comprising:

a reproducing step of reproducing, from a recording medium, a data stream of encoded data which are encoded by an encoding scheme including a run length limit encoding scheme;

a counting step of counting the number of encoded data of said data stream, the number of encoding processes or the number of decoded data;

a last encoded data detecting step of detecting a last encoded data of said data stream based on the value of said counter; and

a decoding step of, when said last encoded data detecting unit detects that a decoding-target encoded data is said last encoded data, decoding said decoding-target encoded data while using at least said decoding-target encoded data and data having a constant value.

**Explanation in accordance with Article 19(1)**

We amended claims 1, 2, 4, 5, 8 through 10, 12, 13, and 16 through 18.

JP8-204569A describes an encoder which inserts a predetermined pattern to encoded data for a predetermined length to thereby reduce DSV and realize DC free. The invention defined in claim 1 and the like are directed to a recording medium, a recording apparatus and the like which require to divide data for each different data length for each zone and insert a predetermined pattern to thereby record a data block containing thus added data in each data recording area. The present invention is based on a totally new concept to associate a pattern inserting position and a recording position in a recording medium. Further, the invention defined in claim 1 and the like has a totally new technical concept of dividing one stream into a plurality of data recording areas and recording.

JP1-319176A describes a decoder circuit which outputs decoded data based on a difference between reproduction signals. The invention defined in claims 8 and 16 are inventions according to which reproduction signals of a plurality of data recording areas whose bit counts are different between zones are binarized except for at least top one bits and combined to thereby generate one data stream.

The invention defined in claims 11 and 19 are completely different from the cited references.

The present invention is different from the cited references in terms of object, structure and effect.

FIG. 1

(a)

(b)

(c)

F I G. 2

F I G. 3

F I G. 4

(a)  0  1  0  0  1  0  0  0  0  1  0  1  0  0  1

(b)

(c)

FIG. 5

FIG. 6

701

INPUT TWO CLOCK SIGNALS
TO D-FF 601 TO 604.
DATA IN D-FF 601, 602 → D-FF 603, 604
NEW INPUT DATA → D-FF 601, 602

702

GENERATE AND OUTPUT ENCODED DATA

703

INPUT THREE CLOCK SIGNALS
TO D-FF 606 TO 609.
DATA IN D-FF 606 TO 609 → OUTPUT DATA
DATA IN D-FF 606 → D-FF 609

F I G. 7

100 :
MAGNETO-
OPTICAL DISK

302 :
OPTICAL
PICK-UP

801

REPRODUCING
AMPLIFIER

310

SYNCHRONIZATION
CLOCK
GENERATING PART

802

A/D
CONVERTOR

804

RAM

803

(1-D) COMPUTING UNIT

807

ECC
DECODER

806

(1-7)
DECODER

805

VITERBI
DECODER

812    902    811    901

DELAYING
ELEMENT

REPRODUCING
DATA

904(a),(b)

903

F I G. 8

FIG. 9

FIG. 10

EP 1 324 336 A1

58

1101

INPUT THREE CLOCK SIGNALS
TO D-FF 1001 TO 1008.
DATA IN D-FF 1004, 1005 → D-FF 1007, 1008
DATA IN D-FF 1001 TO 1003 → D-FF 1004 TO 1006
NEW INPUT DATA (ENCODED DATA)
→ D-FF 1001 TO 1003

1102

GENERATE AND OUTPUT DECODED DATA

1103

INPUT TWO CLOCK SIGNALS TO
D-FF 1010, 1011.
DATA IN D-FF 1010, 1011 → OUTPUT DATA

F I G. 11

(a)

1201

(b) 1203:
HEADER AREA

1202:
DATA RECORDING AREA

| HEADER | GAP | VFO3 | SYNC | DATA FIELD (DATA + RESYNC) | PA | BUFFER |
|--------|-----|------|------|---------------------------|-----|--------|
| (63) | (8) | (27) | (4) | (2458) | (1) | (23) |

1204  1205  1206  1207  1208  1209

| SM | VFO1 | AM | ID1 | VFO2 | AM | ID2 | PA |
|----|------|-----|-----|------|-----|-----|-----|
| (8) | (26) | (1) | (5) | (16) | (1) | (5) | (1) |

1210  1211  1212  1213  1214  1215  1216  1217

FIG. 12

EP 1 324 336 A1

F I G . 1 3

ENCODE INPUT DATA AND GENERATE ECC BLOCK — 1301

GENERATE A PLURALITY OF DEVIDED DATA BLOCKS FROM ONE DATA STREAM (ECC BLOCK) — 1302

ADD PREFIX DATA TO TOP OF TOP DATA BLOCK ADD SUFFIX DATA TO END OF LAST DATA BLOCK — 1303

ENCODE EACH DATA BLOCK — 1304

ADD DATA HAVING CONSTANT VALUE BEFORE TOP DATA BLOCK (INCLUDING PREFIX ENCODED DATA), AND GENERATE DATA BLOCK CONTAINING ADDED DATA — 1305

RECORD TOP DATA BLOCK CONTAINING ADDED DATA IN TOP SEGMENT OF RECORDING MEDIUM — 1306

ADD DATA HAVING THE SAME VALUE AS LAST 1-BIT ENCODED DATA OF PRECEDENT DATA BLOCK BEFORE SECOND DATA BLOCK, AND GENERATE DATA BLOCK CONTAINING ADDED DATA — 1307

RECORD SECOND DATA BLOCK CONTAINING ADDED DATA IN SECOND SEGMENT OF RECORDING MEDIUM — 1308

ADD DATA HAVING THE SAME VALUE AS LAST 1-BIT ENCODED DATA OF PRECEDENT DATA BLOCK BEFORE LAST DATA BLOCK (INCLUDING SUFFIX ENCODED DATA), AND GENERATE DATA BLOCK CONTAINING ADDED DATA — 1309

RECORD LAST DATA BLOCK CONTAINING ADDED DATA IN LAST SEGMENT OF RECORDING MEDIUM — 1310

F I G. 1 4

```
                          ( )
                           │
     ┌─────────────────────┤                    ┌─ 1401
     │          ┌──────────▼──────────────────┐
     │          │ REPRODUCE REPRODUCTION SIGNAL FOR │
     │          │ ONE ECC BLOCK FROM RECORDING MEDIUM │
     │          └──────────┬──────────────────┘
     │                     │                     ┌─ 1402
     │          ┌──────────▼──────────┐
     │          │ CONVERT REPRODUCTION SIGNAL │
     │          │ INTO 10-BIT DIGITAL DATA │
     │          └──────────┬──────────┘
     │                     │                     ┌─ 1403
     │          ┌──────────▼──────────────────┐
     │          │ GENERATE DIFFERENTIAL SIGNAL BETWEEN │
     │          │ TWO CONSECUTIVE REPRODUCTION SIGNALS │
     │          └──────────┬──────────────────┘
     │                     │                     ┌─ 1404
     │     ┌───────────────▼───────────────────────┐
     │     │ CALCULATE PATH MATRIX INDICATIVE OF LIKELIFOOD │
     │     │ FROM DIFFERENTIAL SIGNAL, DETERMINE MOST PROBABLE │
     │     │ PATH, AND BINARIZE DIFFERENTIAL SIGNAL │
     │     └───────────────┬───────────────────────┘
     │                     │                     ┌─ 1405
     │     ┌───────────────▼───────────────────────┐
     │     │ DECODE BINARY DATA BY (1-7) ENCODING SCHEME │
     │     └───────────────┬───────────────────────┘
     │                     │                     ┌─ 1406
     │          ┌──────────▼──────────┐
     │          │ DECODE BY ECC ENCODING SCHEME │
     │          └──────────┬──────────┘
     │                     │                     ┌─ 1407
     │          ┌──────────▼──────────┐
     │          │ OUTPUT AS ONE CONTINUOUS STREAM │
     │          └──────────┬──────────┘
     └─────────────────────┘
```

F I G. 1 5

```
                           ○

                                                    1501
        REPRODUCE REPRODUCTION SIGNAL FOR
        ONE ECC BLOCK FROM RECORDING MEDIUM

                                                    1502
        CONVERT REPRODUCTION SIGNAL INTO 10-BIT DIGITAL DATA

                                                    1503
        GENERATE DIFFERENTIAL SIGNAL BETWEEN
        TWO CONSECUTIVE REPRODUCTION SIGNALS

                                                    1504
        CALCULATE PATH MATRIX INDICATIVE OF LIKELIHOOD FROM
        DIFFERENTIAL SIGNAL, DETERMINE MOST PROBABLE
        PATH, AND BINARIZE DIFFERENTIAL SIGNAL

                                                    1505
             SET COUNTER TO k=0

                                                    1506
         DECODE BINARY DATA THREE BITS
          EACH BY (1-7) ENCODING SCHEME

                                                    1507
                 k = k + 3

                                                    1508
                    IS k
              LAST ENCODED DATA              YES
                  NUMBER?

                     NO

                                                    1509
         INPUT CONSTANT VALUE 001 AND DECODE
        LAST ENCODED DATA BY (1-7) ENCODING SCHEME

                                                    1510
          DECODE BY ECC ENCODING SCHEME

                                                    1511
          OUTPUT AS ONE CONTINUOUS STREAM
```

EP 1 324 336 A1

(a) 103 104

106 111 106 111 106 111 106 106 111 106

(b) 402 403 403 — — — — — — 404 408

406 407 405 405 405

(c) 402 403 403 — — — — — 404 408

407

(d) 402 403 403 403 — — — — 404 408

407

(e) 1601

F I G. 1 6

## INTERNATIONAL SEARCH REPORT

| International application No. |
| --- |
| PCT/JP01/08478 |

A. CLASSIFICATION OF SUBJECT MATTER
   Int.Cl$^7$  G11B20/14, G11B20/10, G11B20/12, G11B7/007, G11B11/105

According to International Patent Classification (IPC) or to both national classification and IPC

B. FIELDS SEARCHED

Minimum documentation searched (classification system followed by classification symbols)
   Int.Cl$^7$  G11B20/10-20/14, G11B7/004, G11B11/105

Documentation searched other than minimum documentation to the extent that such documents are included in the fields searched
   Jitsuyo Shinan Koho      1922-1996    Toroku Jitsuyo Shinan Koho  1994-2001
   Kokai Jitsuyo Shinan Koho 1971-2001    Jitsuyo Shinan Toroku Koho  1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 8-204569 A (Sony Corporation), 09 August, 1996 (09.08.96), Par. Nos. [0020], [0021], [0047] to [0051]; Figs. 1, 7 (Family: none) | 1-7,9-15,17-19 |
| X | JP 1-319176 A (Hitachi, Ltd.), 25 December, 1989 (25.12.89), page 5, lower left column, line 1 to page 5, lower left column, line 18; Fig. 10   (Family: none) | 8,16 |
| A | JP 8-7495 A (Hitachi, Ltd.), 12 January, 1996 (12.01.96), Full text; Figs. 1 to 12   (Family: none) | 1-19 |
| A | JP 5-205402 A (Hitachi, Ltd.), 13 August, 1993 (13.08.93), Full text; Figs. 1 to 7   (Family: none) | 1-19 |

☐ Further documents are listed in the continuation of Box C.    ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 12 December, 2001 (12.12.01) | 25 December, 2001 (25.12.01) |

| Name and mailing address of the ISA/ | Authorized officer |
| --- | --- |
| Japanese Patent Office | |
| Facsimile No. | Telephone No. |

Form PCT/ISA/210 (second sheet) (July 1992)